# EUROPEAN PATENT SPECIFICATION

(11) **EP 4 427 969 B1**
(45) Date of publication and mention of the grant of the patent: **26.08.2026**
(21) Application number: 24161544.2
(22) Date of filing: 05.03.2024
(51) Int. Cl.: B60L 53/16, B60L 53/302, B60L 53/31, H01R 12/71, H01R 12/73, H01R 13/02, H01R 13/502, H01R 13/66, H01R 27/02, H05K 3/36, H05K 7/20, B60L 53/10, B60L 53/18

(54) **CHARGING CONNECTOR AND CHARGING DEVICE**
LADESTECKER UND LADEVORRICHTUNG
CONNECTEUR DE CHARGE ET DISPOSITIF DE CHARGE

(30) Priority: 10.03.2023 CN 202310266074
(43) Date of publication of application: 11.09.2024
(73) Proprietor: Huawei Digital Power Technologies Co., Ltd., Shenzhen, Guangdong 518043 (CN)
(72) Inventor: LI, Wenkang, Shenzhen, 518043 (CN); REN, Junheng, Shenzhen, 518043 (CN); LIAN, Zhisheng, Shenzhen, 518043 (CN); YANG, Zezhou, Shenzhen, 518043 (CN); HU, Minggui, Shenzhen, 518043 (CN)
(74) Representative: Gill Jennings & Every LLP

(56) References cited:
- EP-A1- 4 056 410
- WO-A1-2023/021443
- WO-A1-2023/279940
- CN-A- 114 709 659
- CN-A- 114 899 634
- US-A1- 2012 043 935
- US-A1- 2021 063 097
- US-B2- 10 675 988
- US-B2- 11 084 390

## Description

### TECHNICAL FIELD

This application relates to the field of mechanical device technologies, and in particular, to a charging connector and a charging device.

### BACKGROUND

A charging connector is a connecting apparatus for transmitting electric energy from a charging pile device to an energy storage battery of an electric vehicle. Increasing charging power to shorten charging time is an important method to resolve anxiety about charging of the electric vehicle, and increasing charging power leads to an increase in heat consumption of a power cable and a power terminal of the charging connector. The power terminal is a key device for the charging connector to connect to a vehicle socket to implement power transmission. Due to contact resistance, heat consumption of the power terminal is high. This restricts high-power charging of the electric vehicle.

To resolve a problem of heat generated by high-power charging of the charging connector, the power terminal may be cooled in a liquid cooling manner. However, currently, efficiency of performing liquid cooling on the power terminal is low, and a heat dissipation requirement of high-power charging of the electric vehicle cannot be met.

US20210063097A1 provides a power connector (the charging inlet assembly) including a housing extending between a front and a rear having a chamber at the rear and a terminal channel between the front and the rear. In addition, the power connector includes a terminal coupled to the housing including a mating pin at a front of the terminal and a cable connector at a rear of the terminal. And the power connector includes a heat ex-changer positioned in the chamber of the housing, the heat exchanger is thermally coupled to the pad of the terminal.

WO2023279940A1 provides a motor controller and a vehicle having said motor controller, which comprise: a first box body, the first box body having a first surface and an opposing second surface along the thickness direction of said box body, the first box body being provided with a cooling water channel, the cooling water channel having at least one first opening on the first surface; at least one IGBT module, the at least one IGBT module being arranged on the first surface and inserted into the cooling water channel by means of at least one first opening; a capacitor, the capacitor being arranged on the second surface and connected to the IGBT module.

US11084390 discloses a charging connector with concentric sleeves, manifold, and fluid conduits enclosing sockets. WO2023021443A1 discloses a charging inlet module with terminals, cable connectors, and coolant-channel heat exchanger. CN114709659A discloses a power-pin cooling assembly with housing, cooling unit, pins, and positioning blocks.

### SUMMARY

This application provides a charging connector and a charging device, so that a large-sized heat exchanger can be disposed to improve heat dissipation effect on a power terminal. This helps an electric vehicle implement high-power charging.

According to a first aspect, this application provides a charging connector according to appended claim 1. The invention is defined in the appended claims.

The signal terminal of the charging connector may transmit a signal to the cable by using the first circuit board and the second circuit board, so that large space is reserved on a side on which the second end face of the first circuit board is located. Connection portions of the two power terminals of the liquid cooling structure may be far away from a side on which the second circuit board is located. In a case in which a heat exchange area remains unchanged, the liquid cooling structure can be larger to accommodate more cooling media. When the heat exchanger is larger, a lower temperature rises when the cooling medium absorbs same heat, and heat dissipation efficiency can be improved. In addition, a more appropriate flow channel may be designed based on a heat dissipation requirement in a heat exchanger with a larger size. This also helps improve heat dissipation efficiency.

According to the invention, a flow channel structure is disposed in the heat exchanger of the liquid cooling structure, and the flow channel structure includes a first flow channel section and a second flow channel section. A quantity of the second flow channel sections is two, the two second flow channel sections are in communication with the first flow channel section, so that a cooling medium in the first flow channel section can be simultaneously supplied to the two second flow channel sections. Alternatively, the first flow channel section may simultaneously collect cooling media flowing out of the two second flow channel sections. The two second flow channel sections one-to-one correspond to the heat exchange surfaces of the two power terminals. In other words, each second flow channel section is configured to exchange heat with a heat exchange surface of one power terminal, to implement precise heat exchange. A serpentine channel may be disposed in the two second flow channel sections, to increase a contact area between the heat exchanger and the cooling medium, and improve heat dissipation effect.

In an actual structure of the charging connector, there is a spacing between the two power terminals. The two second flow channel sections in the flow channel structure may be symmetrically disposed on two sides of the first flow channel section, and space occupied by the first flow channel section can correspond to a gap between the two power terminals. This effectively utilizes space and facilitates a structural design of the heat exchanger.

Between the second flow channel section and the heat exchange surface of the power terminal that correspond to each other, an orthographic projection of the second flow channel section on the thermally conductive plate covers an orthographic projection of the heat exchange surface of the power terminal on the thermally conductive plate, so that the second flow channel section can fully exchange heat with the heat exchange surface.

In a possible implementation, one first water nozzle and two second water nozzles are disposed in the heat exchanger, the first water nozzle is in communication with the first flow channel section, and the two second water nozzles are in communication with the two second flow channel sections in a one-to-one correspondence. In a process of circularly cooling the heat exchanger, the first water nozzle may be for liquid inlet and the second water nozzle may be for liquid outlet. Alternatively, the first water nozzle may be for liquid outlet and the second water nozzle may be for liquid inlet. An amount of liquid in and out of the heat exchanger may be accurately controlled by using the first water nozzle and the second water nozzle.

To keep the amount of liquid in and out of the heat exchanger stable, a flow cross-sectional area of the first water nozzle may be set to be greater than a flow cross-sectional area of any second water nozzle. For example, the flow cross-sectional area of the first water nozzle may be a sum of flow cross-sectional areas of the two second water nozzles.

A joint is formed at one end that is of the power terminal and that is far away from the connection portion. When the charging connector charges the electric vehicle, the joint is configured to connect to a charging port of the electric vehicle. A structural rib plate is formed between the joint and the connection portion. When the power terminal is mounted on the first circuit board, the joint is located on a side on which the first end face of the first circuit board is located, and the structural rib plate is in contact with the first end face of the first circuit board.

Generally, a bottom shell of the heat exchanger is a metal structure. To prevent electrical connection or electrical contact between the bottom shell of the heat exchanger and the power terminal, a side that is of the heat exchanger and that faces the joint is provided with a notch, and notch space can be formed between the notch and the thermally conductive plate. An orthographic projection of an end that is of the notch and that is close to the thermally conductive plate on the thermally conductive plate is a first projection, an orthographic projection of an end that is of the heat exchanger and that faces the joint on the thermally conductive plate is a second projection, and the first projection is located on a side that is of the second projection and that is away from the joint. The notch enables a contact position between the heat exchanger and the thermally conductive plate to be far away from the structural rib plate. This can increase a creepage distance between the power terminal and the heat exchanger and enhance safety.

In a possible implementation, the charging connector further includes an insulation member. The insulation member includes an insulation body, and the insulation body is specifically disposed between the heat exchanger and the first circuit board. The insulation member can prevent electrical connection or electrical contact between the heat exchanger and the first circuit board or the structural rib plate, thereby ensuring safety of electrical connection.

Further, the insulation member includes a first insulation portion and a second insulation portion that are connected to the insulation body. Specifically, along a direction in which the structural rib plate points to the connection portion, the first insulation portion extends to a position between the heat exchanger and the thermally conductive plate, and the second insulation portion extends to a side surface of the heat exchanger. Arrangement of the first insulation portion and the second insulation portion further improves electrical safety. When a notch facing the thermally conductive plate is disposed in the heat exchanger, the first insulation portion may be adapted to the notch.

In a possible implementation, the charging connector further includes two pressing plates. The two pressing plates are disposed oppositely along a thickness direction of the heat exchanger, and the heat exchanger, the thermally conductive plate, and the connection portion of the power terminal can be clamped between the two pressing plates. Each pressing plate abuts against the inner wall of the housing to clamp and fasten the liquid cooling structure and the electrical connection structure.

The two pressing plates include a first pressing plate in contact with the heat exchanger, and a pressing reed is disposed on a side that is of the first pressing plate and that faces the heat exchanger. When the two pressing plates oppositely clamp the liquid cooling structure and the electrical connection structure, the pressing reed can provide a pretightening force for the heat exchanger.

According to a second aspect, this application provides a charging device. The charging device includes a charging pile, a connecting cable, and a charging connector. The charging connector herein is the charging connector provided in the first aspect. The charging pile includes a power distribution unit, a liquid storage tank, and a control unit. A cooling medium is stored in the liquid storage tank. The connecting cable includes a cable and a liquid cooling pipe. A power cable in the cable is connected between the power distribution unit and a power terminal, and the power distribution unit may supply power to the power terminal through the power cable. A signal cable in the cable is connected between the control unit and a second circuit board. The control unit is in a signal connection to the power distribution unit, and the control unit may control, based on a status of signal connection between a signal terminal and an electric vehicle, the power distribution unit to supply power to the power terminal. One end of the liquid cooling pipe is in communication with a heat exchange cavity of a heat exchanger, and the other end of the liquid cooling pipe is in communication with the liquid storage tank. The liquid storage tank may circularly cool the heat exchanger through the liquid cooling pipe. The charging connector in the charging device can circularly dissipate heat from the power terminal by using a liquid cooling structure, thereby achieving good heat dissipation effect. This helps implement high-power charging of the electric vehicle.

In a possible implementation, a first water nozzle and a second water nozzle are disposed in the heat exchanger, and a first water opening and a second water opening are disposed in the liquid storage tank. The liquid cooling pipe includes a first pipe and a second pipe, the first pipe is connected between the first water nozzle and the first water opening, and the second pipe is connected between the second water nozzle and the second water opening.

In a possible implementation, a circuit includes an end part and a wire part. The end part is configured to connect to the power terminal and the second circuit board. The wire part includes a plurality of conducting wires. The plurality of conducting wires may be disposed around the first pipe. A cooling medium in the first pipe may exchange heat with the plurality of conducting wires to dissipate heat from the cable. Alternatively, the plurality of conducting wires may be disposed around the second pipe, and a cooling medium in the second pipe may exchange heat with the plurality of conducting wires to dissipate heat from the cable.

### BRIEF DESCRIPTION OF DRAWINGS

FIG. 1a is a schematic diagram of a structure of a charging device according to an embodiment of this application;
FIG. 1b is a schematic diagram of a structure of a charging system of a charging device according to an embodiment of this application;
FIG. 2 is a schematic diagram of a structure of a charging connector according to an embodiment of this application;
FIG. 3a is a simplified diagram of a cross-sectional structure of a charging connector according to an embodiment of this application;
FIG. 3b is a schematic diagram of a structure of an electrical connection structure and a liquid cooling structure of a charging connector according to an embodiment of this application;
FIG. 3c is a schematic diagram of a structure of an electrical connection structure of a charging connector according to an embodiment of this application;
FIG. 3d is a schematic diagram of a structure of an electrical connection structure and a liquid cooling structure of a charging connector according to an embodiment of this application;
FIG. 3e is a schematic diagram of a structure of an electrical connection structure and a liquid cooling structure of a charging connector according to an embodiment of this application;
FIG. 4a is a schematic diagram of a structure of a power terminal and a liquid cooling structure of a charging connector according to an embodiment of this application;
FIG. 4b is an exploded view of a power terminal and a liquid cooling structure of a charging connector according to an embodiment of this application;
FIG. 5a is a schematic diagram of a structure of a power terminal of a charging connector according to an embodiment of this application;
FIG. 5b is a schematic diagram of a structure of a power terminal of a charging connector according to an embodiment of this application;
FIG. 5c is a schematic diagram of a structure of a power terminal of a charging connector according to an embodiment of this application;
FIG. 5d is a schematic diagram of a structure of a power terminal of a charging connector according to an embodiment of this application;
FIG. 6a is a schematic diagram of a structure of a heat exchanger of a charging connector according to an embodiment of this application;
FIG. 6b is a top view of a bottom shell in a heat exchanger of a charging connector according to an embodiment of this application;
FIG. 6c is a top view of a bottom shell in a heat exchanger of a charging connector according to an embodiment of this application;
FIG. 7a is a schematic diagram of a flow path of a cooling medium in a heat exchanger of a charging connector according to an embodiment of this application;
FIG. 7b is a schematic diagram of a flow path of a cooling medium in a heat exchanger of a charging connector according to an embodiment of this application;
FIG. 8a is a schematic diagram of a structure of a heat exchanger of a charging connector according to an embodiment of this application;
FIG. 8b is a left view of a heat exchanger and a power terminal of a charging connector according to an embodiment of this application;
FIG. 8c is an enlarged view of a position C in FIG. 8b;
FIG. 9a is a schematic diagram of a structure of a notch of a heat exchanger of a charging connector according to an embodiment of this application;
FIG. 9b is a schematic diagram of a structure of a notch of a heat exchanger of a charging connector according to an embodiment of this application;
FIG. 9c is a schematic diagram of a structure of a notch of a heat exchanger of a charging connector according to an embodiment of this application;
FIG. 10a is a schematic diagram of some structures of a charging connector according to an embodiment of this application;
FIG. 10b is a schematic diagram of a structure of an insulation member and a heat exchanger of a charging connector according to an embodiment of this application;
FIG. 11a is a schematic diagram of some structures of a charging connector according to an embodiment of this application;
FIG. 11b is a schematic diagram of cooperation between some structures of a charging connector according to an embodiment of this application;
FIG. 12a is a simplified diagram of a cross-sectional structure of a charging connector according to an embodiment of this application;
FIG. 12b is a simplified diagram of a cross-sectional structure of a charging connector according to an embodiment of this application;
FIG. 13a is a schematic diagram of some structures of a charging connector according to an embodiment of this application;
FIG. 13b is a simplified diagram of a cross-sectional structure of a charging connector according to an embodiment of this application;
FIG. 13c is a left view of some structures of a charging connector according to an embodiment of this application;
FIG. 14a is a schematic diagram of a connection structure of some structures of a charging connector and a connecting cable according to an embodiment of this application;
FIG. 14b is a schematic diagram of a connection structure of some structures of a charging connector and a connecting cable according to an embodiment of this application; and
FIG. 15 is a schematic diagram of a connection structure of a heat exchanger and a liquid storage tank of a charging connector according to an embodiment of this application.

Reference numerals: 10-charging connector; 20-charging pile; 201-shell; 202-power distribution unit; 2021-power distribution module; 2022-power module; 203-liquid storage tank; 2031-first water opening; 2032-second water opening; 204-control unit; 30-connecting cable; 301-cable; 3011-end part; 3012-conducting wire; 302-liquid cooling pipe; 3021-first pipe; 3022-second pipe; 1-housing; 11-locking screw; 2-electrical connection structure; 21-power terminal; 211-joint; 2111-insulation cap; 2112-sealing ring; 212-connection portion; 2121-sealing groove; 2122-avoidance groove; 213-structural rib plate; 22-signal terminal; 23-first circuit board; 24-second circuit board; 3-liquid cooling structure; 31-heat exchanger; 311-bottom shell; 3111-first water nozzle; 3112-second water nozzle; 3113-flow channel structure; 31131-first flow channel section; 31132-second flow channel section; 312-top cover; 32-thermally conductive plate; 4-pressing plate; 41-first pressing plate; 411-pressing reed; 42-second pressing plate; 43-protrusion; 5-insulation member; 51-insulation body; 52-first insulation portion; 53-second insulation portion; A-accommodating cavity; M1-heat exchange surface; M2-joint surface; N1-first plate surface; N2-second plate surface; Q-notch; S-heat exchange cavity; a1-charging terminal; a2-wiring end; b1-first side plate; and b2-second side plate.

### DESCRIPTION OF EMBODIMENTS

Electric vehicles are increasingly popular, and requirements for fast charging of the electric vehicles are increasingly urgent. Increasing charging power of a charging connector can shorten charging time, but high-power charging may cause a heat problem. Heat consumption of a power terminal of the charging connector is high. This affects implementation of high-power charging. Currently, the power terminal may be cooled in a liquid cooling manner. The liquid cooling manner mainly includes indirect cooling and immersion cooling. Water and glycol solution is used as coolant for indirect cooling, and insulating oil or fluoride liquid is used as coolant for immersion cooling. Indirect cooling means that a radiator that can implement heat conduction with the power terminal is disposed, and coolant is circulated into the radiator, and the coolant can dissipate heat from the power terminal by using a housing of the radiator to implement heat dissipation. Currently, the radiator is disposed between two power terminals, and it is difficult to achieve a large volume, an amount of contained coolant and a design of a flow channel are limited, and heat dissipation efficiency is low. Hereafter "embodiment(s)" refer to embodiment(s) of the disclosure.

Terms used in the following embodiments are merely intended to describe specific embodiments, but are not intended to limit this application. As used in the specification and the appended claims of this application, the singular expressions "a/an", "one", "said", "the above", "the" and "this" are intended to also include such expressions as "one or more", unless otherwise clearly indicated in the context.

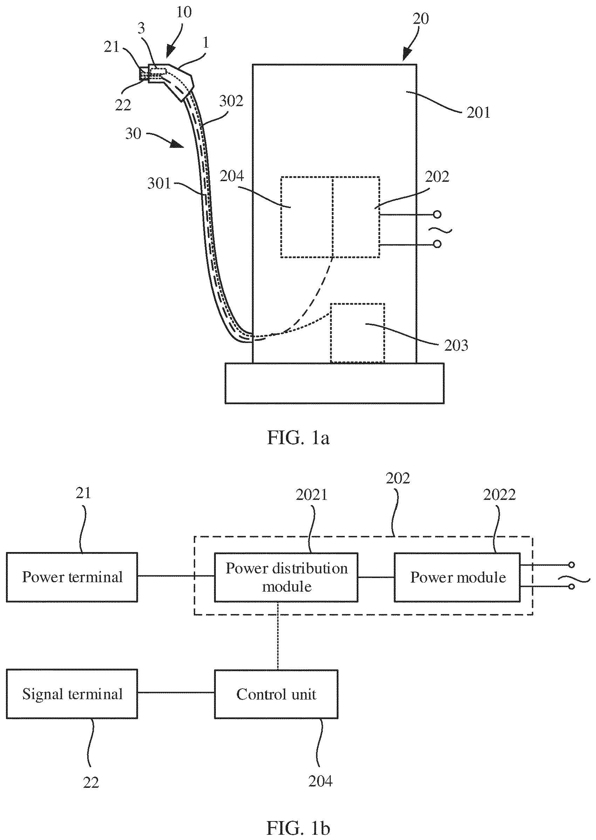

FIG. 1a is a schematic diagram of a structure of a charging device configured to charge an electric vehicle. The charging device may specifically include a charging connector 10, a charging pile 20, and a connecting cable 30 connected between the charging connector 10 and the charging pile 20. The charging pile 20 is generally disposed at a charging station. The charging pile 20 includes a shell 201, and a power distribution system and a liquid storage tank 203 that are disposed in the shell 201. A cooling medium is stored in the liquid storage tank 203, and is configured to provide coolant for the charging connector 10 to perform liquid cooling. The power distribution system includes a power distribution unit 202 and a control unit 204. The power distribution unit 202 is configured to provide electric energy for the charging connector 10 after converting an external power supply. The charging connector 10 specifically includes a housing 1, and a power terminal 21, a signal terminal 22, and a liquid cooling structure 3 that are disposed in the housing 1. The liquid cooling structure 3 is configured to perform liquid cooling on the power terminal 21, to reduce heat consumption of the power terminal 21. A cable 301 and a liquid cooling pipe 302 are disposed in the connecting cable 30. The cable 301 includes a signal cable for signal transmission and a power cable for current transmission. Specifically, the signal cable in the cable 301 is configured to connect the signal terminal 22 to the control unit 204 to implement communication, and the power cable in the cable 301 is configured to connect the power terminal 21 to the power distribution unit 202 to implement current transmission.

For example, FIG. 1b is a schematic diagram of a structure of the power distribution system of the charging device. Specifically, the power distribution unit 202 includes a power distribution module 2021 and a power module 2022, and the power module 2022 is configured to connect to the external power supply. The power distribution module 2021 is electrically connected to the power module 2022, and the power distribution module 2021 is connected to the power terminal 21 by using the power cable in the cable 301. When the electric vehicle is charged, the power module 2022 may convert an alternating current into a direct current, and provide electric energy for the power terminal 21 by using the power distribution module 2021. The control unit 204 is electrically connected to the signal terminal 22, and the control unit 204 is in a signal connection to the power distribution module 2021 in the power distribution unit 202. The control unit 204 may control, based on a status of signal connection between the signal terminal 22 and the electric vehicle, the power distribution module 2021 to supply power to the power terminal 21.

The liquid cooling pipe 302 is connected between the liquid cooling structure 3 and the liquid storage tank 203. When the power terminal 21 of the charging connector 10 is connected to the electric vehicle to charge the electric vehicle, the cooling medium in the liquid storage tank 203 may be circularly transported to the liquid cooling structure 3 through the liquid cooling pipe 302. The cooling medium in the liquid cooling structure 3 can exchange heat with the power terminal 21, and the cooling medium absorbs heat of the power terminal 21 and returns to the liquid storage tank 203 again. In this way, the cooling medium circularly cools the power terminal 21. In other words, the liquid cooling structure 3 can effectively dissipate heat from the power terminal 21, reduce heat consumption of the power terminal 21, and facilitate high-power charging of the electric vehicle. It should be understood that, to perform circularly liquid cooling on the power terminal 21, the liquid cooling pipe 302 has a liquid inlet pipe and a liquid outlet pipe. This is described in detail later.

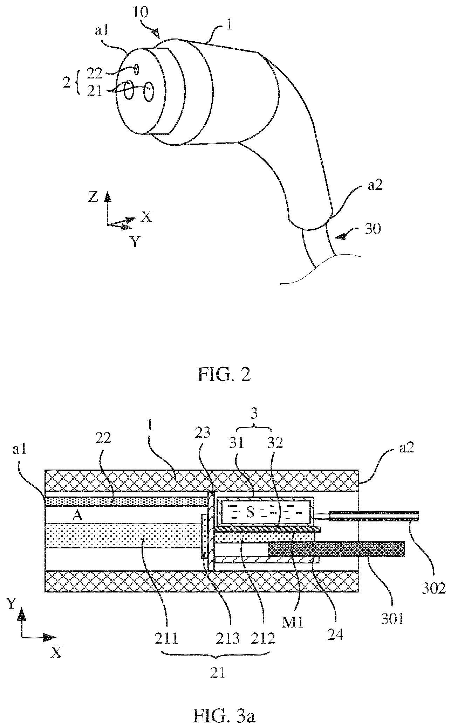

A structure of the charging connector 10 is shown in FIG. 2, and the charging connector 10 includes the housing 1 and an electrical connection structure 2. The housing 1 has a charging end a1 and a wiring end a2. The charging terminal a1 is configured to connect to a charging port of the electric vehicle, and the wiring end a2 is configured to connect to the connecting cable 30. Two power terminals 21 are disposed, and the two power terminals 21 are disposed side by side. One signal terminal 22 is used as an example. The power terminal 21 and the signal terminal 22 are configured to connect to a charging port of the electric vehicle, and the power terminal 21 and the signal terminal 22 are exposed from the charging terminal a1 of the housing 1. Certainly, there is another component or structure in the housing 1 of the charging connector 10. This is not illustrated herein.

Still refer to FIG. 2. The two power terminals 21 are disposed side by side, an axial direction of the power terminal 21 is set to a first direction X, and the axial direction of the power terminal 21 is an extension direction of the power terminal 21. The two power terminals 21 are disposed along a second direction Y, the first direction X is perpendicular to the second direction Y, and a third direction Z is perpendicular to the first direction X and the second direction Y For ease of understanding, the following embodiments are described with reference to a three-dimensional coordinate system constituted by the first direction X, the second direction Y, and the third direction Z.

FIG. 3a is a simplified schematic diagram of a cross-sectional structure of the charging connector 10. The charging connector 10 further includes the liquid cooling structure 3. An accommodating cavity A is formed in the housing 1, and the power terminal 21, the signal terminal 22, and the liquid cooling structure 3 are all disposed in the accommodating cavity A. The power terminal 21 and the signal terminal 22 are exposed from the charging terminal a1 of the housing 1. The electrical connection structure 2 further includes a first circuit board 23 and a second circuit board 24. The first circuit board 23 may be fastened to the accommodating cavity A formed in the housing 1 of the charging connector 10 by using a connecting piece, for example, a screw, and the second circuit board 24 is connected to the first circuit board 23. Along the first direction X, the first circuit board 23 has a first end face and a second end face. In FIG. 3a, a side that is of the first circuit board 23 and that faces the charging terminal a1 is the first end face, and a side that is of the first circuit board 23 and that is away from the charging terminal a1 is the second end face. The signal terminal 22 is connected to the first end face of the first circuit board 23, and the second circuit board 24 is connected to the second end face of the first circuit board 23. The circuit board has a function of transmitting an electrical signal, and also has a function of processing an electrical signal to implement communication. The first circuit board 23 can implement an electrical signal connection between the signal terminal 22 and the second circuit board 24. The second circuit board 24 is connected to the second end face of the first circuit board 23, and is configured to connect to the signal cable in the cable 301. The signal terminal 22 may be connected to the control unit 204 of the charging pile 20 by using the first circuit board 23, the second circuit board 24, and the signal cable in the cable 301 to implement communication. For example, the first circuit board 23 is perpendicular to the second circuit board 24, and a plane on which the second circuit board 24 is located is parallel to the first direction X. The first circuit board 23 and the second circuit board 24 may be connected by using a pin terminal, or may be connected by using a flexible cable. It should be understood that this is not limited in embodiments of this application.

Still refer to FIG. 3a. Along the axial direction of the power terminal 21, the power terminal 21 includes a joint 211 and a connection portion 212. The joint 211 is located on a side on which the first end face of the first circuit board 23 is located, and the connection portion 212 is located on a side on which the second end face of the first circuit board 23 is located. The joint 211 and the signal terminal 22 are disposed in an approximately parallel manner, and the joint 211 and the signal terminal 22 are configured to connect to the charging port of the electric vehicle. The connection portion 212 and the second circuit board 24 are disposed in an approximately parallel manner. The connection portion 212 and the second circuit board 24 may be configured to connect to the power cable in the cable 301, to implement an electrical connection between the power terminal 21 and the power distribution module 2021 in the charging pile 20. For example, the cable 301 is located between the connection portion 212 and the second circuit board 24, so that the power cable in the cable 301 is connected to the connection portion 212, and the signal cable in the cable 301 is connected to the second circuit board 24. A structural rib plate 213 may also be disposed between the joint 211 and the connection portion 212. A surface that is of the structural rib plate 213 and that faces the connection portion 212 abuts against a surface that is of the first circuit board 23 and that is away from the second circuit board 24, and the connection portion 212 passes through the first circuit board 23 and is located on a side that is of the first circuit board 23 and that faces the second circuit board 24. It should be noted that, the power terminal 21 is mounted on the first circuit board 23, and there is only a structural mounting and cooperation relationship between the power terminal 21 and the first circuit board 23, and there is no circuit connection relationship between the power terminal 21 and the first circuit board 23. During specific mounting, the power terminal 21 may be fastened to the housing 1 by using a structure, for example, a frame. This is not illustrated herein.

Based on the structure shown in FIG. 3a, the signal terminal 22 may be routed by using the first circuit board 23 and the second circuit board 24 to a side on which the bottom of the connection portion 212 of the power terminal 21 is located, so that space on a side on which the top of the connection portion 212 of the power terminal 21 is located may be released. As shown in FIG. 3a, a heat exchange surface M1 is disposed on the side on which the top of the connection portion 212 is located. The heat exchange surface M1 is parallel to the axial direction of the power terminal 21 and an arrangement direction of the two power terminals 21, and is specifically parallel to a plane constituted by the first direction X and the second direction Y. The heat exchange surface M1 faces the liquid cooling structure 3, and the liquid cooling structure 3 is in contact with the heat exchange surface M1 to perform heat exchange. The liquid cooling structure 3 specifically includes a heat exchanger 31 and a thermally conductive plate 32. The thermally conductive plate 32 is in contact with the heat exchange surface M1 of the power terminal 21. The heat exchanger 31 has a heat exchange cavity S, and the heat exchange cavity S is for circulation of the cooling medium. The heat exchanger 31 is disposed on a side that is of the thermally conductive plate 32 and that is away from the heat exchange surface M1 of the power terminal 21. Heat emitted by the power terminal 21 may be transferred to the thermally conductive plate 32 by using the connection portion 212. The thermally conductive plate 32 transfers the heat to the heat exchanger 31. The cooling medium in the heat exchanger 31 absorbs the heat of the thermally conductive plate 32 to perform heat exchange, to dissipate heat from the power terminal 21. Refer to FIG. 2 and FIG. 3a. The heat exchanger 31 is in communication with the liquid cooling pipe 302 in the connecting cable 30. The liquid cooling pipe 302 can circularly send the cooling medium to the heat exchanger 31, to dissipate heat from the power terminal 21.

It should be noted that an auxiliary source terminal and a ground terminal are further disposed in the charging connector 10. The auxiliary source terminal may be selectively connected to the first circuit board 23, to be electrically connected to the control unit 204 of the charging pile 20 by using the second circuit board 24. The ground terminal is for grounding. When the auxiliary source terminal and the ground terminal are disposed, related positions and a connection structure may also be adjusted based on a requirement, to reserve sufficient space for the heat exchanger 31.

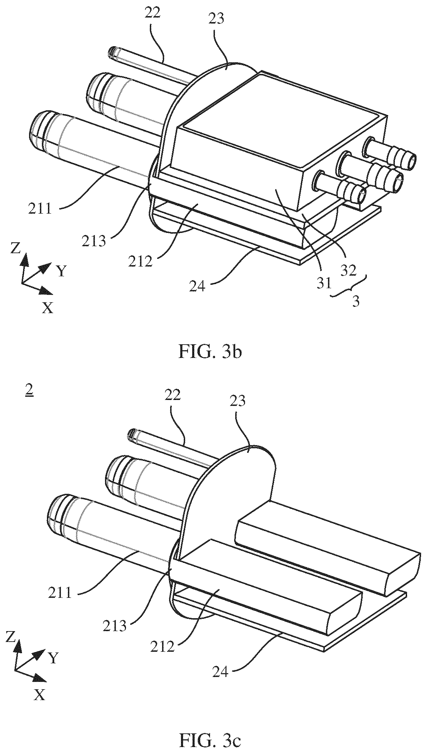

FIG. 3b is a schematic diagram of a structure in which the electrical connection structure 2 cooperates with the liquid cooling structure 3, and FIG. 3c is a schematic diagram of a structure of the electrical connection structure 2. The thermally conductive plate 32 is in contact with connection portions 212 of the two power terminals 21, and the heat exchanger 31 is disposed on a side that is of the thermally conductive plate 32 and that is away from the power terminal 21. Along the third direction Z, the heat exchanger 31, the thermally conductive plate 32, and the two power terminals 21 are sequentially stacked. The signal terminal 22 is electrically connected to the second circuit board 24 by using the first circuit board 23. The connection portion 212 of the power terminal 21 and the second circuit board 24 may be configured to connect the cable 301 in the connecting cable 30. Along the first direction X, the signal terminal 22 and the heat exchanger 31 are respectively located on two sides of the first circuit board 23. Along the third direction Z, the heat exchanger 31 and the connection portion 212 are respectively located on two sides of the thermally conductive plate 32. With the first circuit board 23 as a reference, the signal terminal 22 is located on only one side on which the first end face of the first circuit board 23 is located, and does not occupy space on one side on which the second end face of the first circuit board 23 is located, so that large space is reserved on the side on which the second end face of the first circuit board 23 is located. Based on the structure in FIG. 3b, along the third direction Z, the side on which the top of the connection portion 212 of the power terminal 21 is located has large space. The heat exchanger 31 is disposed on the side on which the top of the connection portion 212 is located, so that a large volume can be achieved, thereby accommodating more cooling media and improving cooling efficiency.

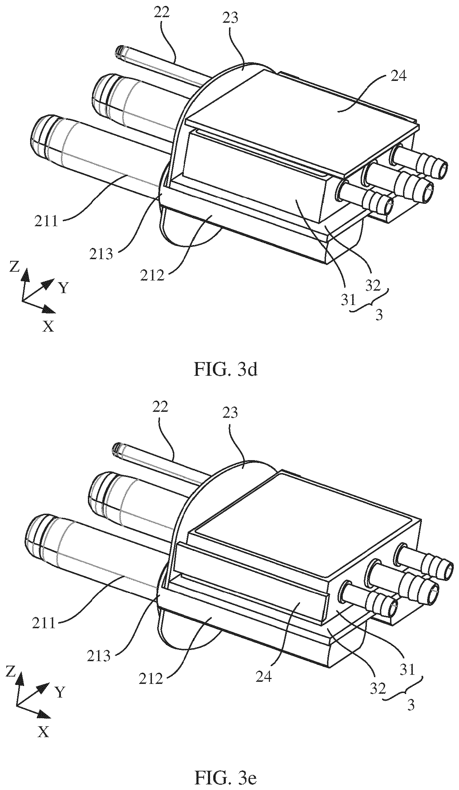

It should be understood that both the heat dissipation surface M1 on the power terminal 21 and the second circuit board 24 are located on a side on which the second end surface of the first circuit board 23 is located, but positions of the heat dissipation surface M1 and the second circuit board 24 are not limited. As shown in FIG. 3b, the heat dissipation surface M1 is located on a side that is of the power terminal 21 and that is away from the second circuit board 24. In some embodiments, as shown in FIG. 3d, the second circuit board 24 and the heat dissipation surface M1 may alternatively be located on a same side of the power terminal 21. Alternatively, as shown in FIG. 3e, the second circuit board 24 may be disposed on a side of the heat exchanger 31 along the second direction Y. Certainly, after a position of the second circuit board 24 is adjusted, a connection manner between the second circuit board 24 and the power cable in the cable 301 should also be adjusted accordingly, for example, the second circuit board 24 and the power cable in the cable 301 are connected by using a flexible connection line. Alternatively, a part of the second circuit board 24 is bent to a position of the connection portion 212 of the power terminal 21 in a manner of a flexible circuit board, so that the power terminal 21 and the connection portion 212 of the second circuit board 24 can be connected to the cable 301. It may be considered that the second circuit board 24 occupies small space, and a position of the second circuit board 24 may be adjusted based on a requirement, so that large space can be reserved for the heat exchanger 31.

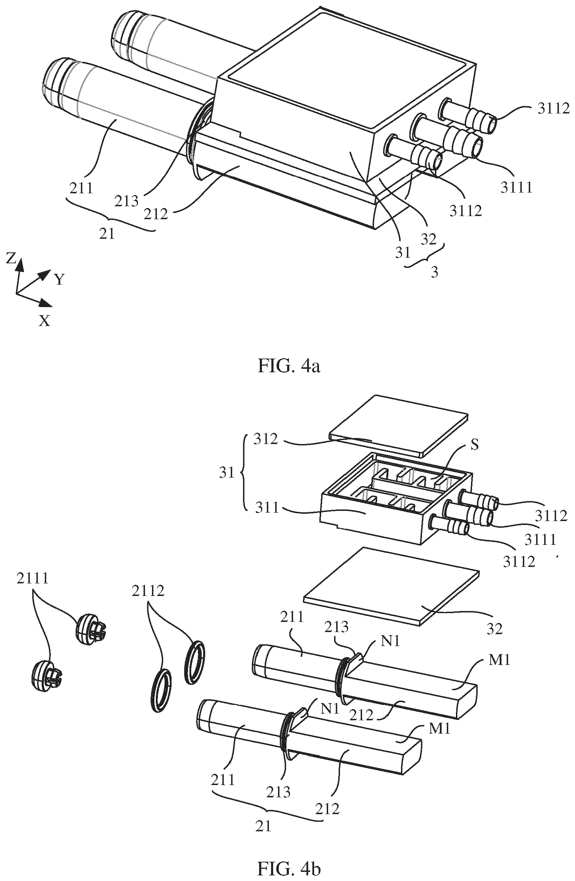

FIG. 4a is a schematic diagram of a structure in which the liquid cooling structure 3 cooperates with the power terminal 21. FIG. 4b is an exploded view of the liquid cooling structure 3 and the power terminal 21. For ease of illustration, the first circuit board 23, the second circuit board 24, and the signal terminal 22 are not shown herein.

Refer to FIG. 4a and FIG. 4b. The heat exchanger 31 includes a bottom shell 311 and a top cover 312. The bottom shell 311 is in a shape of an open box, and the top cover 312 is adapted and fastened to an opening of the bottom shell 311, so that a heat dissipation cavity S can be formed between the bottom shell 311 and the top cover 312. The heat dissipation cavity S is configured to contain the cooling medium. A first water nozzle 3111 and a second water nozzle 3112 are further disposed in the bottom shell 311, and the first water nozzle 3111 and the second water nozzle 3112 are separately communicated with the heat dissipation cavity S. The first water nozzle 3111 may be configured to send the cooling medium into the heat dissipation cavity S, and the second water nozzle 3112 is configured to output the cooling medium in the heat dissipation cavity S. Alternatively, the second water nozzle 3112 is configured to send the cooling medium into the heat dissipation cavity S, and the first water nozzle 3111 is configured to output the cooling medium in the heat dissipation cavity S. It should be understood that quantities and positions of the first water nozzles 3111 and the second water nozzles 3112 are not limited, and only an example in which the heat exchanger 31 includes a liquid inlet structure and a liquid outlet structure is provided. One first water nozzle 3111 and two second water nozzles 3112 are used as an example here.

For example, the first water nozzle 3111 is for liquid inlet and the second water nozzle 3112 is for liquid outlet. When the heat exchanger 31 exchanges heat with the thermally conductive plate 32, the first water nozzle 3111 sends the cooling medium with a low temperature to the heat dissipation cavity S. In a process in which the cooling medium with the low temperature circulates in the heat dissipation cavity S, the cooling medium with the low temperature absorbs heat of the thermally conductive plate 32 by using the bottom shell 311, so that the temperature of the cooling medium increases, and the cooling medium with the increased temperature is discharged from the second water nozzle 3112. Therefore, the cooling medium in the heat exchanger 31 may dissipate heat from the power terminal 21 by exchanging heat with the thermally conductive plate 32, thereby implementing cooling and heat dissipation on the power terminal 21. In a specific structural design, the quantities and positions of the first water nozzles 3111 and the second water nozzles 3112 may be related to a structural form of the heat dissipation cavity S, to form a proper flow channel in the heat dissipation cavity S. In this way, good heat exchange effect can be achieved in a flow process of the cooling medium in the heat dissipation cavity S.

Still refer to FIG. 4b. The heat exchange surface M1 is on a side that is of the connection portion 212 of the power terminal 21 and that faces the thermally conductive plate 32, and heat exchange surfaces M1 of the two power terminals 21 remain coplanar during mounting. When the thermally conductive plate 32 is in contact with the connection portion 212 of the power terminal 21, the thermally conductive plate 32 can be in contact with the heat exchange surfaces M1 of the two power terminals 21 at the same time. An area of a surface that is of the thermally conductive plate 32 and that is away from the heat exchanger 31 is greater than a sum of areas of the heat exchange surfaces M1 of the two power terminals 21. The heat exchange surface M1 may be considered as a heat exchange surface M1 between the power terminal 21 and the thermally conductive plate 32. When the thermally conductive plate 32 is in contact with the heat exchange surfaces M1 of the two power terminals 21 at the same time, orthographic projections of the heat exchange surfaces M1 of the two power terminals 21 on the thermally conductive plate 32 fall within a range of a surface that is of the thermally conductive plate 32 and that is away from the heat exchanger 31. In this way, the heat exchange surface M1 of the power terminal 21 can fully contact the thermally conductive plate 32, thereby ensuring a sufficiently large heat exchange area. The orthographic projection of the heat exchange surface M1 on the thermally conductive plate 32 is a projection of the heat exchange surface M1 on the thermally conductive plate 32 along a direction perpendicular to the heat exchange surface M1.

Possibly, a heat conduction medium may be disposed between the heat exchange surface M1 of the power terminal 21 and the thermally conductive plate 32, to reduce heat transfer resistance. A heat conduction medium may also be disposed between the heat exchanger 31 and the thermally conductive plate 32. It should be understood that the heat conduction medium may be disposed between the heat exchange surface M1 of the power terminal 21 and the thermally conductive plate 32, and between the heat exchanger 31 and the thermally conductive plate 32, the heat conduction medium may be disposed only between the heat exchange surface M1 of the power terminal 21 and the thermally conductive plate 32, or the heat conduction medium may be disposed only between the heat exchanger 31 and the thermally conductive plate 32. The heat conduction medium may specifically include but is not limited to thermally conductive adhesive and thermal grease.

Refer to FIG. 4a and FIG. 4b. A direction in which the joint 211 points to the connection portion 212 is the axial direction of the power terminal 21, and it may also be considered that a direction in which the connection portion 212 points to the joint 211 is the axial direction of the power terminal 21. The structural rib plate 213 formed between the joint 211 and the connection portion 212, and the power terminal 21 may be of an integrated structure. In a direction perpendicular to the axial direction of the power terminal 21, a size of the structural rib plate 213 is greater than a size of the joint 211 and a size of the connection portion 212. For example, the structural rib plate 213 has a first plate surface N1 facing the connection portion 212. When the heat exchanger 31 is mounted on a side that is of the thermally conductive plate 32 and that is away from the power terminal 21, there is a gap between an end that is of the heat exchanger 31 and that faces the joint 211 and the first plate surface N1. An insulation cap 2111 and a sealing ring 2112 are further disposed in the power terminal 21. One insulation cap 2111 is correspondingly disposed on the joint 211 of each power terminal 21, and the insulation cap 2111 and the joint 211 may be detachably connected through thread fitting, clamping, or the like. The insulation cap 2111 has effect of preventing electric shock, and can improve use safety of the charging connector 10. The sealing ring 2112 is disposed at a connection point between the joint 211 and the structural rib plate 213. The sealing ring 2112 can cooperate with an end face structure in the housing 1 to prevent external liquid from entering a side that is of the structural rib plate 213 and that is away from the joint 211 and causing a security risk. This is not illustrated herein.

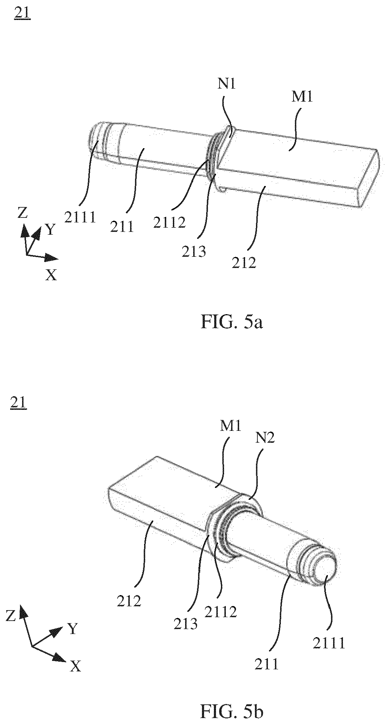

FIG. 5a and FIG. 5b are schematic diagrams of structures of the power terminal 21. The joint 211 and the structural rib plate 213 of the power terminal 21 may be of an integrated structure, or the joint 211, the structural rib plate 213, and the connection portion 212 may be of an integrated structure. For example, the first plate surface N1 and a second plate surface N2 are perpendicular to the first direction X and parallel to each other. Refer to FIG. 3c. When the power terminal 21 is mounted on the first circuit board 23, the first plate surface N1 of the structural rib plate 213 abuts against the first end surface that is of the first circuit board 23 that is away from the second circuit board 24.

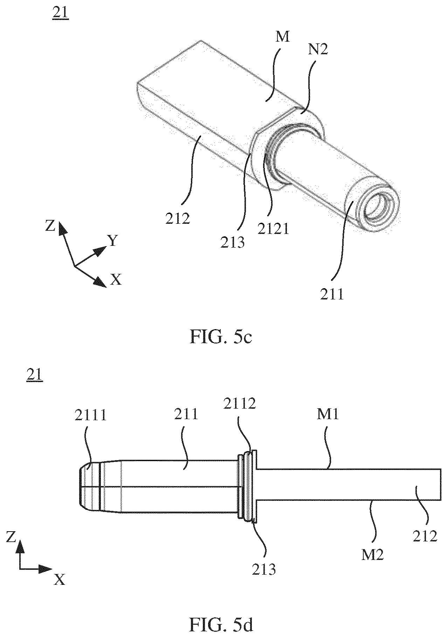

Further, with reference to the structure of the power terminal 21 shown in FIG. 5c, the insulation cap 2111 and the sealing ring 2112 are not shown. An end that is of the insulation cap 211 and that is away from the structural rib plate 213 is hole-shaped for mounting the joint 2111. A sealing groove 2121 is disposed between the joint 211 and the structural rib plate 213, and the sealing ring 2112 may be accommodated in the sealing groove 2121 to implement mounting and fit.

FIG. 5d shows a left side view of the power terminal 21. The heat exchange surface M1 is perpendicular to the third direction Z. Possibly, along the third direction Z, a connection surface M2 is further disposed in the connection portion 212 of the power terminal 21. When the power terminal 21 is mounted in the housing 1 of the charging connector 10, the connection surface M2 may be used to cooperate with another structure. For example, the connection surface M2 herein is also perpendicular to the third direction Z.

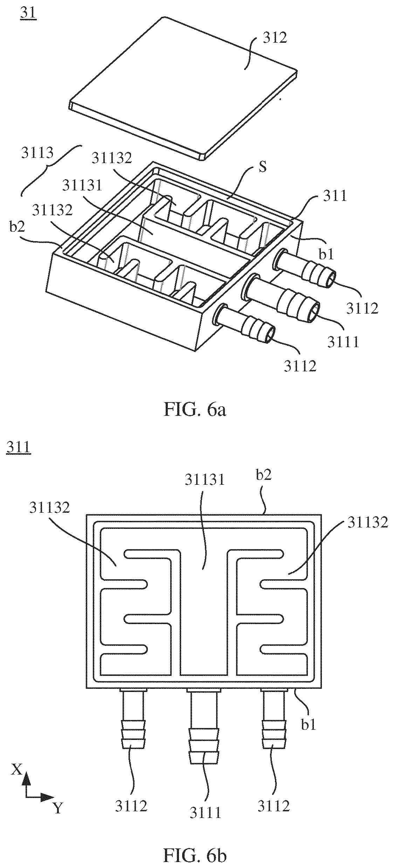

In a structure of the heat exchanger 31 shown in FIG. 6a, space enclosed by the bottom of the bottom shell 311 and a side wall is in an open box shape, and the top cover 312 may be fastened to an opening of the bottom shell 311. It may be considered that the space constituted by the bottom shell 311 is space of the heat dissipation cavity S. A flow channel structure 3113 is disposed in the heat dissipation cavity S. The flow channel structure 3113 is configured to form flow space of the cooling medium, and provide a guide for flow of the cooling medium in the heat dissipation cavity S. For example, the flow channel structure 3113 includes a first flow channel section 31131 and two second flow channel sections 31132. The two second flow channel sections 31132 are respectively disposed on two sides of the first flow channel section 31131. The first flow channel section 31131 corresponds to the first water nozzle 3111, and each second flow channel section 31132 corresponds to one second water nozzle 3112. Therefore, the two second water nozzles 3112 are respectively disposed on both sides of the first water nozzle 3111. The first water nozzle 3111 and the second water nozzles 3112 are disposed on a first side plate b1 of the bottom shell 311, and the bottom shell 311 has a second side plate b2 opposite to the first side plate b1. The first flow channel section 31131 communicates with the two second flow channel sections 31132 at the second side plate b2. The first water nozzle 3111 and the second water nozzles 3112 are disposed on a same side, so that the liquid cooling pipe 302 in the connecting cable 30 circularly supplies liquid to the heat dissipation cavity S by using the first water nozzle 3111 and the second water nozzles 3112.

FIG. 6b is a top view of the bottom shell 311. The two second flow channel sections 31132 separately form a serpentine channel between an inlet and an outlet. When the cooling medium flows in the second flow channel section 31132, a flow path of the cooling medium extends in a serpentine shape, so that the cooling medium can fully exchange heat with the thermally conductive plate 32 by using the bottom shell 311.

Refer to FIG. 6a and FIG. 6b. The first water nozzle 3111 and the second water nozzles 3112 are disposed on the first side plate b1 of the bottom shell 311. It is convenient for the first water nozzle 3111 and the second water nozzles 3112 to communicate with the liquid storage tank 203 of the charging pile 20 by using the liquid cooling pipe 302 of the connecting cable 30, and the cooling medium in the liquid storage tank 203 may circularly cool the heat exchanger 31 through the liquid cooling pipe 302 of the connecting cable 30.

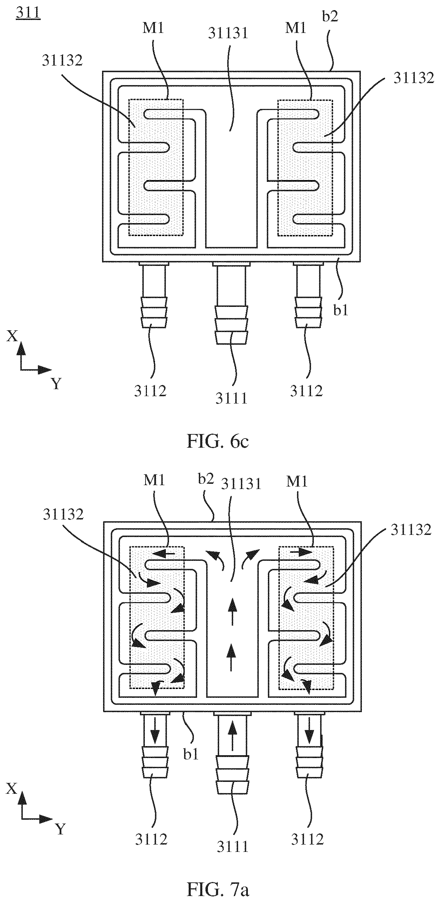

When the heat exchanger 31 and the power terminal 21 perform mounting and cooperation by using the thermally conductive plate 32, as shown in FIG. 6c, orthographic projections of the heat exchange surfaces M1 of the two power terminals 21 on the heat exchanger 31 along the third direction Z respectively correspond to the two second flow channel sections 31132. In other words, each second flow channel section 31132 exchanges heat with a heat exchange surface M1 of one power terminal 21 by using the thermally conductive plate 32 and the bottom shell 311. The heat exchange surface M1 is shown in dashed shade. It should be understood that, between the second flow channel section 31132 and the heat exchange surface M1 that correspond to each other, along the third direction, an orthographic projection of the second flow channel section 31132 on the bottom shell 311 covers at least an orthographic projection of the heat exchange surface M1 on the bottom shell 311, so that the cooling medium flowing in the second flow channel section 31132 can fully exchange heat with the heat exchange surface M1.

The heat dissipation cavity S in the heat exchanger 31 is divided into the first flow channel section 31131 and the two second flow channel sections 31132, and the first flow channel section 31131 is disposed between the two second flow channel sections 31132, so that the cooling media in the two second flow channel sections 31132 respectively exchange heat with the heat exchange surfaces M1 of the corresponding power terminals 21. However, there is a gap between the two power terminals 21, and the gap may correspond to the first flow channel section 31131. With such a structure arrangement, the cooling media in the two second flow channel sections 31132 can fully exchange heat with the heat exchange surfaces M1 of the corresponding power terminals 21, and the gap between the two power terminals 21 can be for the cooling medium to flow, thereby making full use of space, and achieving a smaller volume under a condition of good heat dissipation.

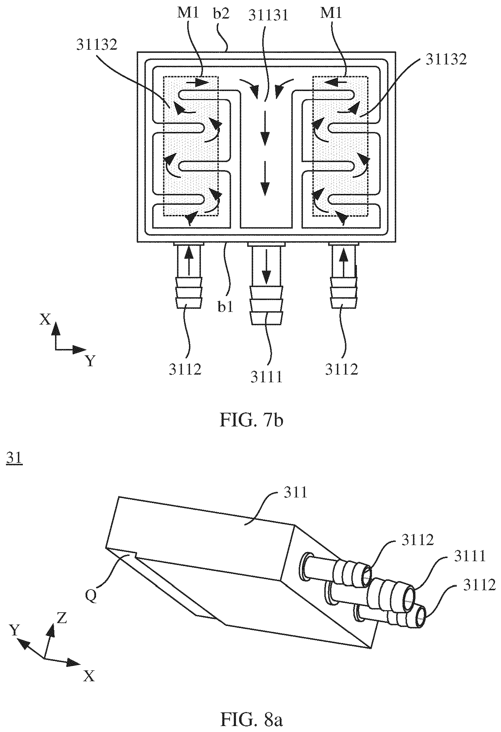

FIG. 7a and FIG. 7b show an example of a flow path of the cooling medium in the heat dissipation cavity S of the heat exchanger 31.

As shown in FIG. 7a, the first water nozzle 3111 is for liquid inlet, and the two second water nozzles 3112 are for liquid outlet. The cooling medium enters the first flow channel section 31131 from the first water nozzle 3111, and flows to the second side plate b2 of the bottom shell 311 in the first flow channel section 31131 along a direction in which the first side plate b1 points to the second side plate b2. Then, the cooling medium in the first flow channel section 31131 enters the two second flow channel sections 31132 in two ways. The cooling medium entering the second flow channel section 31132 flows in a serpentine manner, and an overall flow direction is a direction in which the second side plate b2 points to the first side plate b1. Finally, the cooling medium in the second flow channel section 31132 flows out from the corresponding second water nozzle 3112.

As shown in FIG. 7b, the second water nozzle 3112 is for liquid inlet, and the first water nozzle 3111 is for liquid outlet. The cooling media enter the corresponding second flow channel sections 31132 from the two second water nozzles 3112, and flow in a serpentine manner in the second flow channel sections 31132. In the direction in which the first side plate b1 points to the second side plate b2, the cooling medium flows to the second side plate b2 of the bottom shell 311 in the second flow channel section 31132. Then, cooling media in the two second flow channel sections 31132 converge into the first flow channel section 31131. The cooling medium entering the first flow channel section 31131 flows out of the first water nozzle 3111 in the direction in which the second side plate b2 points to the first side plate b1.

Refer to FIG. 7a and FIG. 7b. When the cooling medium circulates in the second flow channel section 31132, heat of the power terminal 21 may be transferred to the cooling medium through the heat exchange surface M1, the thermally conductive plate 32, and the bottom wall of the bottom shell 311 for absorption. As the cooling medium flows out from the second water nozzle 3112, heat of the power terminal 21 is dissipated, thereby implementing heat dissipation for the power terminal 21.

To ensure that inlet liquid and outlet liquid of the heat exchange cavity S of the heat exchanger 31 are kept equal, a flow cross-sectional area of the first water nozzle 3111 may be set to be greater than a flow cross-sectional area of any second water nozzle 3112. In this way, an amount of cooling medium flowing through the first water nozzle 3111 per unit time is greater than that an amount of cooling medium flowing through a single second water nozzle 31112 per unit time. Possibly, the flow cross-sectional area of the first water nozzle 3111 is equivalent to flow cross-sectional areas of the two second water nozzles 3112. For example, the flow cross-sectional area of the first water nozzle 3111 may be set as a sum of the flow cross-sectional areas of the two second water nozzles 3112. In this structure, the amount of cooling medium flowing through the first water nozzle 3111 per unit time is a sum of amounts of cooling medium flowing through the two second water nozzles 3112. For example, the first water nozzle 3111 is for liquid inlet and the two second water nozzles 3112 are for liquid outlet. A liquid inlet volume and a liquid outlet volume of the heat exchange cavity S of the heat exchanger 31 may be kept equal to each other, thereby ensuring stable supply of the cooling medium. During operation, different control structures may be added to cooperate with the first water nozzle 3111 and the second water nozzle 3112 to accurately control liquid volumes in the first flow channel section 31131 and the second flow channel section 31132.

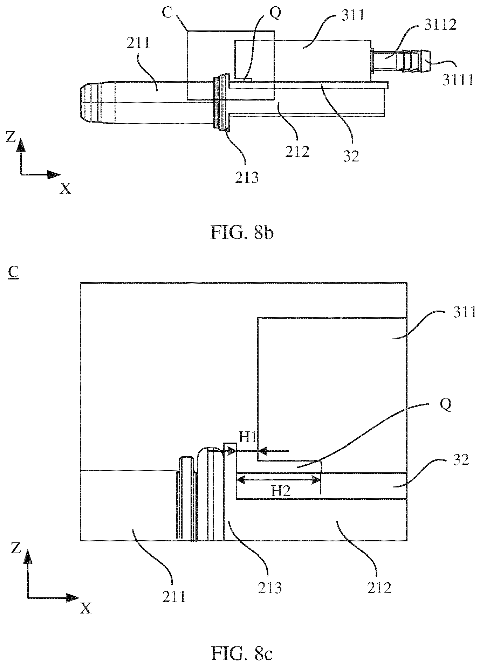

In some embodiments, the bottom shell 311 of the heat exchanger 31 is made of a metal material. As shown in FIG. 8a, a side of the bottom of the heat exchanger 31 is provided with a notch Q, and the side of the bottom the heat exchanger 31 is a side of the bottom shell 311. When the heat exchanger 31, the thermally conductive plate 32, and the power terminal 21 are fitted together, refer to the structure shown in FIG. 8b. The notch Q on the bottom shell 311 of the heat exchanger 31 is specifically located at an edge between a surface that is of the heat exchanger 31 and that faces the structural rib plate 213 and a surface that is of the heat exchanger 31 and that faces the thermally conductive plate 32. The notch Q enables notch space to be formed between the heat exchanger 31 and the thermally conductive plate 32. An orthographic projection of an end that is of the notch Q and that is close to the thermally conductive plate 32 on the thermally conductive plate 32 is a first projection, an orthographic projection of an end that is of the bottom shell 311 of the heat exchanger 31 and that faces the joint 211 on the thermally conductive plate 32 is a second projection, and the first projection is located on a side that is of the second projection and that is away from the joint 211.

Further refer to an enlarged view at C in FIG. 8b shown in FIG. 8c. Along the first direction X, a distance between the structural rib plate 213 and an end that is of the bottom shell 311 and that is close to the structural rib plate 213 is H1. Due to the notch Q at the bottom of the bottom shell 311, a distance between the structural rib plate 213 and a contact point between the bottom shell 311 and the thermally conductive plate 32 is H2. Along the first direction X, a creepage distance between the structural rib plate 213 and the bottom shell 311 is at least not less than H2. In other words, due to the notch Q, the creepage distance between the structural rib plate 213 and the bottom shell 311 may be increased, and a risk of creepage occurring between the structural rib plate 213 and the bottom shell 311 through a contaminant that may occur on a surface of the thermally conductive plate 32 is reduced due to a sufficiently large creepage distance, thereby increasing safety.

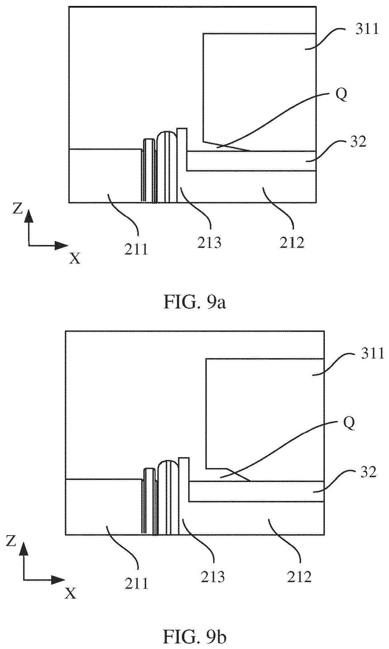

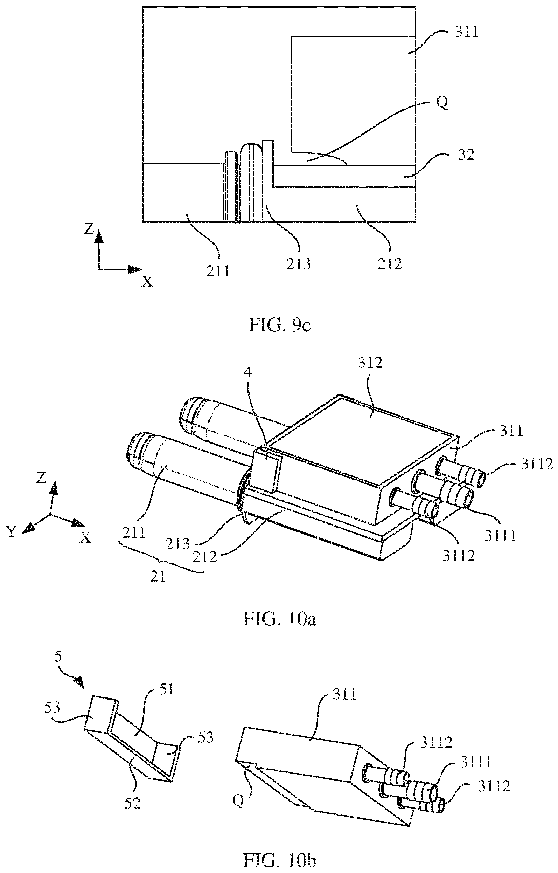

For example, as shown in FIG. 9a to FIG. 9c, a shape and a structure of the notch Q may have a plurality of implementations. This is not limited in embodiments of this application, provided that the creepage distance between the structural rib plate 213 and the bottom shell 311 can be increased due to the notch Q.

In some embodiments, as shown in FIG. 10a, the charging connector 10 further includes an insulation member 5. The insulation member 5 may be disposed between the bottom shell 311 of the heat exchanger 31 and the structural rib plate 213 to provide insulation protection. In an exploded view shown in FIG. 10b, the insulation member 5 includes an insulation body 51, and the insulation body 51 is disposed between the bottom shell 311 of the heat exchanger 31 and the structural rib plate 213. For example, the insulation body 51 is perpendicular to the first direction X. The insulation member 5 further includes a first insulation portion 52 connected to the insulation body 51. The first insulation portion 52 may extend to a position between the bottom shell 311 of the heat exchanger 31 and the thermally conductive plate 32. As shown in FIG. 10b, when the bottom shell 311 of the heat exchanger 31 is provided with the notch Q, a structure of the first insulation portion 52 may be disposed to match the notch Q. When the insulation member 5 is mounted between the heat exchanger 31 and the structural rib plate 213, the first insulation portion 52 can extend into the notch Q. For example, the first insulation portion 52 is parallel to the first direction X and the second direction Y In addition, the insulation member 5 may further include a second insulation portion 53 connected to the insulation body 51. The second insulation portion 53 may extend to a side surface that is of the bottom shell 311 of the heat exchanger 31 and that is perpendicular to the second direction Y, to further improve an insulation protection function of the insulation member 5. Based on a cooperation manner between the bottom shell 311 of the heat exchanger 31 and the insulation member 5, two second insulation portions 53 are disposed, the two second insulation portions 53 are disposed oppositely along the second direction Y, and each second insulation portion 53 is perpendicular to the second direction Y. When the insulation member 5 cooperates with the bottom shell 311 of the heat exchanger 31, the two second insulation portions 53 are in contact with outer walls of the two side plates of the bottom shell 311 along the second direction Y.

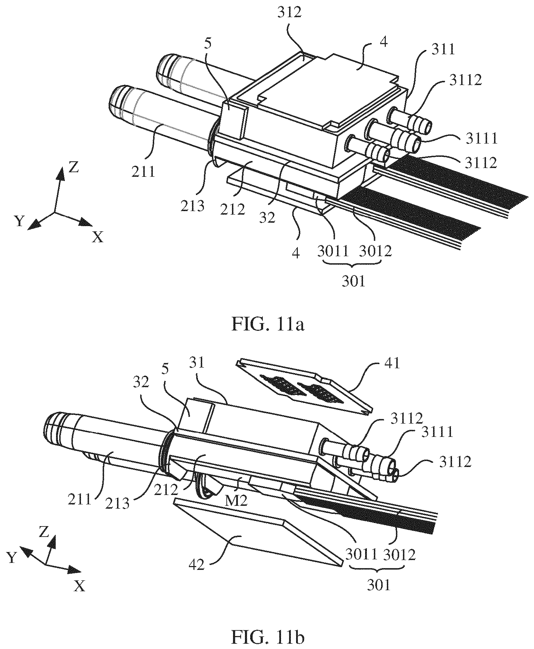

As shown in FIG. 11a, the charging connector 10 further includes two pressing plates 4. The two pressing plates 4 are oppositely disposed along a direction from the heat exchanger 31 to the thermally conductive plate 32. It may also be considered that the two pressing plates 4 are oppositely disposed along the third direction Z. The heat exchanger 31, the thermally conductive plate 32, and the connection portion 212 of the power terminal 21 may be clamped between the two pressing plates 4. Specifically, when an end part 3011 of the cable 301 of the connecting cable 30 is welded, through ultrasonic, to a side that is of the connection portion 212 and that is away from the thermally conductive plate 32, the heat exchanger 31, the thermally conductive plate 32, the connection portion 212 of the power terminal 21, and the end part 3011 of the cable 301 may be clamped and fastened by the two pressing plates 4 along the third direction Z. Due to the end part 3011 of the cable 301, there is a gap between the connection portion 212 and the pressing plate 4.

Further refer to the exploded view of some structures shown in FIG. 11b. A pressing reed 411 is disposed on a side that is of a first pressing plate 41 and that faces the heat exchanger 31. After the heat exchanger 31, the thermally conductive plate 32, the power terminal 21, and the end part 3011 of the cable 301 are clamped by the two pressing plates 4, the pressing reed 411 can provide a pretightening force for the heat exchanger 31. The end part 3011 of the cable 301 of the connecting cable 30 is fastened to the connection surface M2 of the connection portion 212 through an ultrasonic welding process.

As shown in FIG. 11a and FIG. 11b, the cable 301 further includes a wire part connected to the end part 3011, and the wire part includes a plurality of conducting wires 3012 formed in a bundle shape. Here, the plurality of conducting wires 3012 form the flat wire part, and a thickness of the wire part is kept equal to a thickness of the end part 3011.

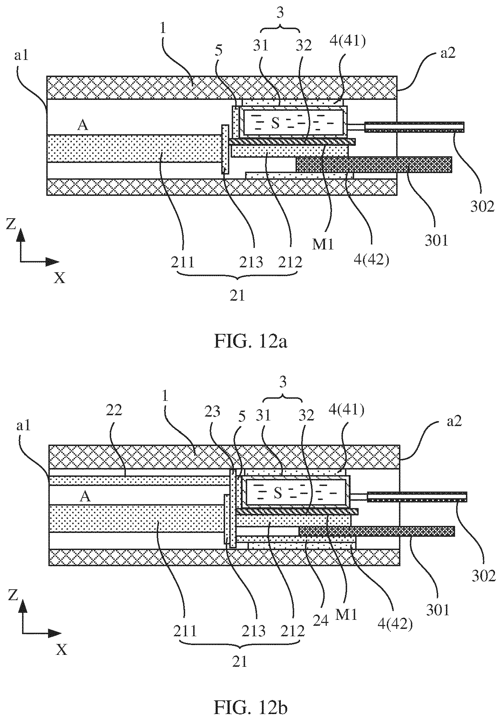

FIG. 12a is a simplified diagram of a cross-sectional structure of the charging connector 10 after the liquid cooling structure 3 and the power terminal 21 are mounted in the housing 1. For ease of distinguishing, a pressing plate 4 in contact with the heat exchanger 31 is set as the first pressing plate 41, and a pressing plate 4 in contact with the end part 3011 of the cable 301 is set as a second pressing plate 42. The first pressing plate 41 is located between an inner wall of the housing 1 and the top of the heat exchanger 31, and the second pressing plate 42 is located between the inner wall of the housing 1 and the end part 3011 of the cable 301. In this way, the heat exchanger 31, the thermally conductive plate 32, the connection portion 212 of the power terminal 21, and the end part 3011 of the cable 301 are clamped and fastened.

Further, as shown in FIG. 12b, when the electrical connection structure 2 includes the signal terminal 22, the first circuit board 23, and the second circuit board 24, the end part 3011 of the cable 301 is located between the connection portion 212 and the second circuit board 24. In this case, the second pressing plate 42 may be specifically disposed on a side that is of the second circuit board 24 and that is away from the connection portion 212. In other words, the second pressing plate 42 is located between the inner wall of the housing 1 and the second circuit board 24. In other words, specific positions of the two pressing plates 4 need to be adjusted based on specific positions of the electrical connection structure 2 and the liquid cooling structure 3 in the charging connector 10, and are mainly used to clamp and fasten the liquid cooling structure 3 and the electrical connection structure 2.

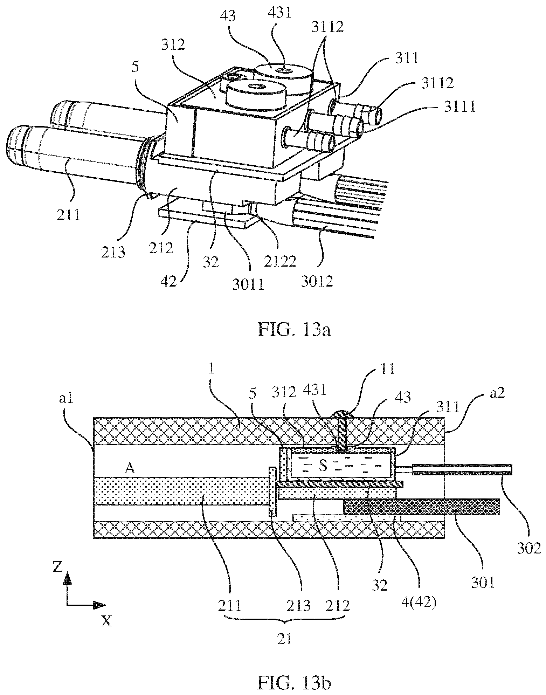

Certainly, the first pressing plate 41 and the second pressing plate 42 may have different implementations in application. In some embodiments, as shown in FIG. 13a, the first pressing plate 41 may replace a protrusion 43 having a groove portion 431. The protrusion 43 may be disposed on the top cover 312 of the heat exchanger 31. For example, the protrusion 43 and the top cover 312 may be of an integrated structure. When the first pressing plate 41 is disposed in the housing 1, as shown in FIG. 13b, a locking screw 11 passing through the housing 1 may be disposed on the housing 1, and the locking screw 11 is disposed at a position corresponding to the groove portion 431 on the protrusion 43. A head portion of the locking screw 11 is located outside the housing 1, and a rod portion of the locking screw 11 passes through the housing 1 and enters the accommodating cavity A and extends into the groove portion 431 on the protrusion 43. In this case, one end that is of the rod portion of the locking screw 11 and that is away from the head portion abuts against the groove bottom of the groove portion 431, and the locking screw 11 may be rotated, so that the locking screw 11 further approaches the top cover 312, and the rod portion of the locking screw 11 further applies pressure to the top cover 312. In this way, the heat exchanger 31, the heat exchange plate 32, and the connection portion 212 of the power terminal 21 are clamped and fastened in cooperation with the second pressing plate 42. It should be understood that FIG. 13b illustrates only a case in which one protrusion 43 is disposed on the top cover 312. Certainly, a plurality of protrusions 43may be disposed based on a requirement. When a plurality of protrusions 43 are disposed, the protrusions 43 cooperate with the locking screw 11 to perform clamping and fastening, points of an acting force can be dispersed, and more balanced clamping and fastening effect is achieved.

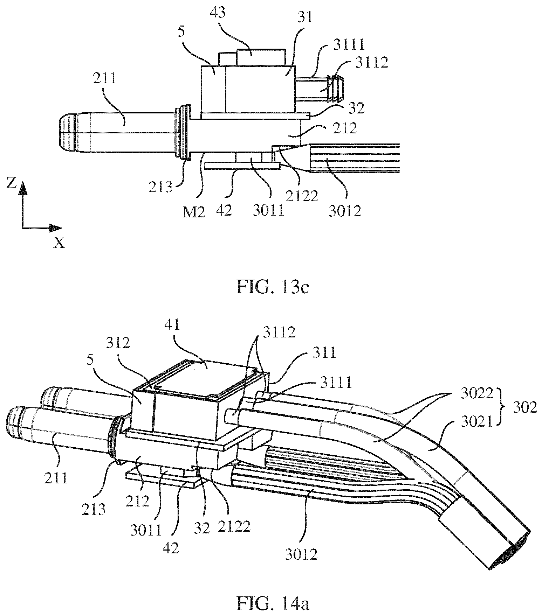

In the example in FIG. 13a, the wire part of the cable 301 is a cylindrical shape. In other words, the plurality of conducting wires 3012 are clustered in a similar cylindrical shape. The end part 3011 of the cable 301 is flat to facilitate welding to the bottom of the connection portion 212 of the power terminal 21. Along the third direction Z, a size of the wire part of the cable 301 is greater than a size of the end part 3011. Further, with reference to FIG. 13c, an avoidance groove 2122 may be further disposed at one end that is of the connection portion 212 of the power terminal 21 and that is configured to connect to the cable 301. Specifically, the avoidance groove 2122 is located on a side that is of the connection surface M2 of the connection portion 212 and that faces the cable 301, and is located at an end that is of the connection portion 212 and that is away from the joint211. The avoidance groove 2122 reserves larger mounting space for the cable 301, and the mounting space can meet a change in a radial direction from the end part 3011 to the wire part of the cable 301.

As shown in FIG. 14a, when the heat exchanger 31 is in communication with the liquid cooling pipe 302, the liquid cooling pipe 302 specifically includes a first pipe 3021 and two second pipes 3022. The first pipe 3021 is connected between the first water nozzle 3111 and the liquid storage tank 203 of the charging pile 20. The two second pipes 3022 correspond to the two second water nozzles 3112, and between the second pipe 3022 and the second water nozzle 3112 that correspond to each other, the second pipe 3022 is connected between the second water nozzle 3112 and the liquid storage tank 203 of the charging pile 20.

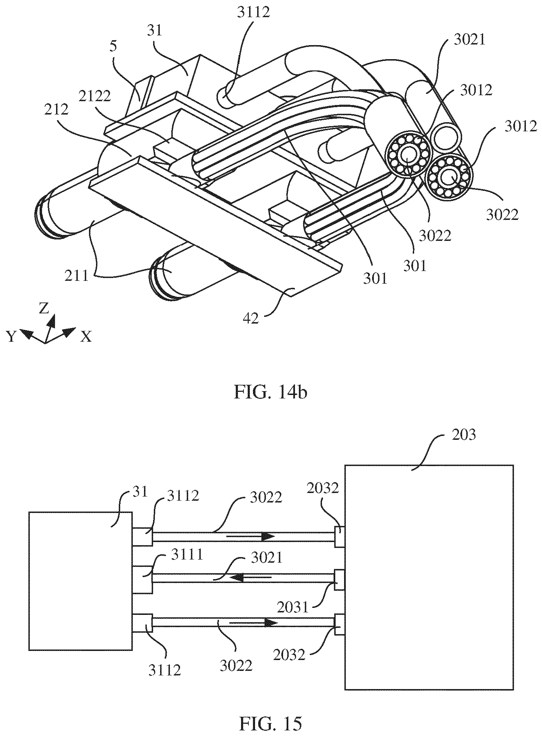

The two second pipes 3022 one-to-one correspond to the two cables 301. Between the corresponding second pipe 3022 and the cable 301, the second pipe 3022 extends from the corresponding second nozzle 3112 to be bundled with the cable 301. Further refer to FIG. 14b. The cable 301 includes a plurality of conducting wires 3012, and the plurality of conducting wires 3012 are disposed around the second pipe 3022. When the cooling medium flows in the second pipe 3022, the cooling medium may exchange heat with the conducting wire 3012 of the cable 301 by using the second pipe 3022, thereby implementing heat dissipation for the cable 301.

Based on structures of the second pipe 3022 and the cable 301, when the second pipe 3022 is configured to input a cooling medium with a low temperature to the heat exchanger 31 by using the second water nozzle 3112, the cooling medium that is in the heat exchanger 31 and whose temperature increases after absorbing heat of the power terminal 21 is output from the first pipe 3021 by using the first water nozzle 3111. In this arrangement, the cooling medium first exchanges heat with the cable 301, and then enters the heat exchanger 31 to exchange heat with the power terminal 21. When the first pipe 3021 is configured to input a cooling medium with a low temperature to the heat exchanger 31 by using the first water nozzle 3111, the cooling medium that is in the heat exchanger 31 and whose temperature increases after absorbing heat of the power terminal 21 is output from the second pipe 3022 by using the second water nozzle 3112. In this arrangement, the cooling medium first enters the heat exchanger 31 to exchange heat with the power terminal 21, and then exchanges heat with the cable 301.

FIG. 15 is a schematic diagram of circulating liquid cooling formed through communication between the heat exchanger 31 and the liquid storage tank 203 of the charging pile 20. A cooling medium is stored in the liquid storage tank 203. A first water opening 2031 and two second water openings 2032 are disposed in the liquid storage tank 203. The first water opening 2031 is connected to the first water nozzle 3111 of the heat exchanger 31 by using the first pipe 3021. The two second water openings 2032, the two second pipes 3022, and the two second water nozzles 3112 are in a one-to-one correspondence. In other words, one second water opening 2032 correspond to one second pipe 3022 and one second water nozzle 3112. Between the second water opening 2032, the second pipe 3022, and the second water nozzle 3112 that correspond to each other, the second water opening 2032 is communicated with the second water nozzle 3112 by using the second pipe 3022. When the first water opening 2031 is for liquid outlet, the second water opening 2032 is for liquid inlet. The cooling medium in the liquid storage tank 203 may be output through the first water opening 2031, and enter the heat exchanger 31 through the first pipe 3021 and the first water nozzle 3111. The cooling medium that enters the heat exchanger 31 exchanges heat with the power terminal 21, is output through the second water nozzle 3112, and returns to the liquid storage tank 203 through the second pipe 3022 and the second water opening 2032, thereby implementing circulation of the cooling medium. It should be understood that a heat exchange apparatus is disposed in the liquid storage tank 203 to cool the cooling medium that returns to the liquid storage tank 203, so that the output cooling medium keeps a low temperature, and performs a next round of cooling medium circulation.

## Claims

1. A charging connector (10), comprising a housing (1), an electrical connection structure (2), and a liquid cooling structure (3), wherein the electrical connection structure (2) and the liquid cooling structure (3) are disposed in the housing (1);
the electrical connection structure (2) comprises a first circuit board (23), a second circuit board (24), a signal terminal (22), and two power terminals (21), wherein the first circuit board (23) is fastened to the housing (1), along an axial direction of the power terminals (21) the first circuit board (23) has a first end face and a second end face that are opposite to each other, the signal terminal (22) is connected to the first end face of the first circuit board (23), and the second circuit board (24) is connected to the second end face of the first circuit board (23), the signal terminal (22) is electrically connected to the first circuit board (23), the first circuit board (23) is electrically connected to the second circuit board (24), the second circuit board (24) is configured to connect to a signal cable in a cable (301); **said** cable (301) is included in a connecting cable (30) that is configured to be connected to the charging connector (10);
the two power terminals (21) are mounted side by side on the first circuit board (23), each power terminal (21) is insulated from the first circuit board (23), and each power terminal (21) has a connection portion (212) located on a side on which the second end face of the first circuit board (23) is located, a heat exchange surface (M1) is disposed on the connection portion (212), the heat exchange surface (M1) is parallel to the axial direction of the power terminal (21), and heat exchange surfaces (M1) of the two power terminals (21) are coplanar; and
the liquid cooling structure (3) comprises a heat exchanger (31) and a thermally conductive plate (32), the heat exchanger (31) has a heat exchange cavity (S), the heat exchange cavity (S) is configured to accommodate a cooling medium, the thermally conductive plate (32) is in contact with the heat exchange surfaces (M1) of the two power terminals (21),and the heat exchanger (31) is in contact with the thermally conductive plate (32),
wherein a flow channel structure (3113) is disposed in the heat exchange cavity (S) of the heat exchanger (31), the flow channel structure (3113) comprises a first flow channel section (31131) and two second flow channel sections (31132), the two second flow channel sections (31132) are separately in communication with the first flow channel section (31131), and the two second flow channel sections (31132) one-to-one correspond to the heat exchange surfaces (M1) of the two power terminals (21);
the first flow channel section (31131) is disposed between the two second flow channel sections (31132); and
between the second flow channel section (31132) and the heat exchange surface (M1) of the power terminal (21) that correspond to each other, an orthographic projection of the second flow channel section (31132) on the thermally conductive plate (32) covers an orthographic projection of the heat exchange surface (M1) of the power terminal (21) on the thermally conductive plate (32).

2. The charging connector (10) according to claim 1, wherein a first water nozzle (3111) and two second water nozzles (3112) are disposed in the heat exchanger (31), the first water nozzle (3111) is in communication with the first flow channel section (31131), and the two second water nozzles (3112) are in communication with the two second flow channel sections (3112) in a one-to-one correspondence.

3. The charging connector (10) according to claim 23, wherein a flow cross-sectional area of the first water nozzle (3111) is greater than a flow cross-sectional area of any second water nozzle (3112).

4. The charging connector (10) according to any one of claims 1 to 3, wherein a joint (211) is formed at one end that is of each power terminal (21) and that is away from the connection portion (212), and a structural rib plate (213) is formed between the joint (211) and the connection portion (212), in a direction perpendicular to the axial direction of the power terminal (21), a size of the structural rib plate (213) is greater than a size of the joint (211) and a size of the connection portion (212);
a surface that is of the structural rib plate (213) and that faces the connection portion (212) abuts against a surface that is of the first circuit board (23) and that is away from the second circuit board (24), and the connection portion (212) passes through the first circuit board (23) and is located on a side that is of the first circuit board (23) and that faces the second circuit board (24).

5. The charging connector (10) according to claim 4, wherein a side that is of the heat exchanger (31) and that faces the joint (211) is provided with a notch (Q), and notch space is formed between the notch (Q) and the thermally conductive plate (32); and
an orthographic projection of an end that is of the notch (Q) and that is close to the thermally conductive plate (32) on the thermally conductive plate (32) is a first projection, an orthographic projection of an end that is of the heat exchanger (31) and that faces the joint (211) on the thermally conductive plate (32) is a second projection, and the first projection is located on a side that is of the second projection and that is away from the joint (211).

6. The charging connector (10) according to claim 4 or 5, wherein the charging connector (10) further comprises an insulation member (5), the insulation member (5) comprises an insulation body (51), and the insulation body (51) is disposed between the heat exchanger (31) and the first circuit board (23).

7. The charging connector (10) according to claim 6, wherein the insulation member (5) comprises a first insulation portion (52) and a second insulation portion (53) that are connected to the insulation body (51); and
in a direction in which the structural rib plate (213) points to the connection portion (212), the first insulation portion (52) extends to a position between the heat exchanger (31) and the thermally conductive plate (32), and the second insulation portion (53) extends to a side surface of the heat exchanger (31).

8. The charging connector (10) according to any one of claims 1 to 7, wherein the charging connector (10) further comprises two pressing plates (4), the two pressing plates (4) are disposed oppositely along a thickness direction of the heat exchanger (31), the heat exchanger (31), the thermally conductive plate (32), and the connection portion (212) of the power terminal (21) are clamped between the two pressing plates (4), and each pressing plate (4) abuts against an inner wall of the housing (1).

9. The charging connector (10) according to claim 8, wherein the two pressing plates (4) comprise a first pressing plate (41) in contact with the heat exchanger (31), and a pressing reed (411) is disposed on a side that is of the first pressing plate (41) and that faces the heat exchanger (31).

10. A charging device, comprising a charging pile (20), a connecting cable (30), and a charging connector (10) according to claim 1, wherein
the charging pile (20) comprises a power distribution unit (202), a liquid storage tank (203), and a control unit (204), wherein the control unit (204) is configured to control, based on a status of signal connection between the signal terminal (22) and an electric vehicle, the power distribution unit (202) to supply power to the two power terminals (21), the power distribution unit (202) includes a power distribution module (2021) and a power module (2022), the power distribution module (2021) is electrically connected to the power module (2022), the power module (2022) is configured to convert an alternating current into a direct current; a cooling medium is stored in the liquid storage tank (203); the connecting cable (30) comprises two cables (301) and a liquid cooling pipe (302), the two cables (301) and the two power terminals (21) are connected in a one-to-one correspondence; a power cable in each cable (301) is connected between the power distribution module (2021) of the power distribution unit (202) and the corresponding power terminal (21); a signal cable in each cable (301) is connected between the control unit (204) and the second circuit board (24); and one end of the liquid cooling pipe (302) is in communication with the heat exchange cavity (S) of the heat exchanger (31), and the other end of the liquid cooling pipe (302) is in communication with the liquid storage tank (203).

11. The charging device according to claim 10, wherein a first water nozzle (3111) and two second water nozzles (3112) are disposed in the heat exchanger (31), and a first water opening (2031) and two second water openings (2032) are disposed in the liquid storage tank (203); and the liquid cooling pipe (302) comprises a first pipe (3021) and two second pipes (3022), the first pipe (3021) is connected between the first water nozzle (3111) and the first water opening (2031), the two second water openings (2032), the two second pipes (3022), and the two second water nozzles (3112) are in a one-to-one correspondence, and one second pipe (3022) is connected between one second water nozzle (3112) and one second water opening (2032).

12. The charging device according to claim 11, wherein the number of cables (301) is two, two cables (301) one-to-one correspond to the two second pipes (3022), each cable (301) comprises an end part (3011) and a wire part, and the end part (3011) is configured to connect the power terminal (21) to the second circuit board (24); and the wire part comprises a plurality of conducting wires (3012), and the plurality of conducting wires (3012) are disposed around the first pipe (3021), or the plurality of conducting wires (3012) are disposed around the corresponding second pipe (3022).

## Patentansprüche

1. Ladestecker (10), umfassend ein Gehäuse (1), eine elektrische Verbindungsstruktur (2) und eine Flüssigkeitskühlstruktur (3), wobei die elektrische Verbindungsstruktur (2) und die Flüssigkeitskühlstruktur (3) in dem Gehäuse (1) angeordnet sind; die elektrische Verbindungsstruktur (2) eine erste Leiterplatte (23), eine zweite Leiterplatte (24), einen Signalanschluss (22) und zwei Leistungsanschlüsse (21) umfasst, wobei die erste Leiterplatte (23) an dem Gehäuse (1) entlang einer axialen Richtung der Leistungsanschlüsse (21) befestigt ist, die erste Leiterplatte (23) eine erste Stirnfläche und eine zweite Stirnfläche aufweist, die einander gegenüberliegen, der Signalanschluss (22) mit der ersten Stirnfläche der ersten Leiterplatte (23) verbunden ist und die zweite Leiterplatte (24) mit der zweiten Stirnfläche der ersten Leiterplatte (23) verbunden ist, der Signalanschluss (22) elektrisch mit der ersten Leiterplatte (23) verbunden ist, die erste Leiterplatte (23) elektrisch mit der zweiten Leiterplatte (24) verbunden ist, die zweite Leiterplatte (24) dazu konfiguriert ist, mit einem Signalkabel in einem Kabel (301) verbunden zu werden; das Kabel (301) in einem Verbindungskabel (30) beinhaltet ist, das dazu konfiguriert ist, mit dem Ladestecker (10) verbunden zu werden; die zwei Leistungsanschlüsse (21) nebeneinander auf der ersten Leiterplatte (23) montiert sind, jeder Leistungsanschluss (21) gegenüber der ersten Leiterplatte (23) isoliert ist und jeder Leistungsanschluss (21) einen Verbindungsabschnitt (212) aufweist, der sich auf einer Seite befindet, auf der sich die zweite Stirnfläche der ersten Leiterplatte (23) befindet, eine Wärmeaustauschfläche (M1) auf dem Verbindungsabschnitt (212) angeordnet ist, die Wärmeaustauschfläche (M1) parallel zu der axialen Richtung des Leistungsanschlusses (21) verläuft und Wärmeaustauschflächen (M1) der zwei Leistungsanschlüsse (21) komplanar sind; und
die Flüssigkeitskühlstruktur (3) einen Wärmetauscher (31) und eine wärmeleitende Platte (32) umfasst, der Wärmetauscher (31) einen Wärmeaustausch-Hohlraum (S) aufweist, der Wärmeaustausch-Hohlraum (S) dazu konfiguriert ist, ein Kühlmedium aufzunehmen, die wärmeleitende Platte (32) mit den Wärmeaustauschflächen (M1) der zwei Leistungsanschlüsse (21) in Kontakt steht und der Wärmetauscher (31) mit der wärmeleitenden Platte (32) in Kontakt steht,
wobei eine Strömungskanalstruktur (3113) in dem Wärmeaustausch-Hohlraum (S) des Wärmetauschers (31) angeordnet ist, die Strömungskanalstruktur (3113) einen ersten Strömungskanalabschnitt (31131) und zwei zweite Strömungskanalabschnitte (31132) umfasst, die zwei zweiten Strömungskanalabschnitte (31132) getrennt voneinander mit dem ersten Strömungskanalabschnitt (31131) in Verbindung stehen und die zwei zweiten Strömungskanalabschnitte (31132) eins zu eins den Wärmeaustauschflächen (M1) der zwei Leistungsanschlüsse (21) entsprechen;
der erste Strömungskanalabschnitt (31131) zwischen den zwei zweiten Strömungskanalabschnitten (31132) angeordnet ist; und zwischen dem zweiten Strömungskanalabschnitt (31132) und der Wärmeaustauschfläche (M1) des Leistungsanschlusses (21), die einander entsprechen, eine orthografische Projektion des zweiten Strömungskanalabschnitts (31132) auf die wärmeleitende Platte (32) eine orthografische Projektion der Wärmeaustauschfläche (M1) des Leistungsanschlusses (21) auf die wärmeleitende Platte (32) abdeckt.

2. Ladestecker (10) nach Anspruch 1, wobei eine erste Wasserdüse (3111) und zwei zweite Wasserdüsen (3112) in dem Wärmetauscher (31) angeordnet sind, die erste Wasserdüse (3111) mit dem ersten Strömungskanalabschnitt (31131) in Verbindung steht und die zwei zweiten Wasserdüsen (3112) mit den zwei zweiten Strömungskanalabschnitten (3112) in einer Eins-zu-Eins-Entsprechung in Verbindung stehen.

3. Ladestecker (10) nach Anspruch 23, wobei eine Durchflussquerschnittsfläche der ersten Wasserdüse (3111) größer ist als eine Durchflussquerschnittsfläche einer beliebigen zweiten Wasserdüse (3112).

4. Ladestecker (10) nach einem der Ansprüche 1 bis 3, wobei an einem Ende, das zu jedem Leistungsanschluss (21) gehört und das von dem Verbindungsabschnitt (212) abgewandt ist, ein Anschlussstück (211) ausgebildet ist und zwischen dem Anschlussstück (211) und dem Verbindungsabschnitt (212) eine strukturelle Rippenplatte (213) in einer Richtung senkrecht zu der axialen Richtung des Leistungsanschlusses (21) ausgebildet ist, wobei eine Größe der strukturellen Rippenplatte (213) größer ist als eine Größe des Anschlussstücks (211) und eine Größe des Verbindungsabschnitts (212);
eine Fläche, die zu der strukturellen Rippenplatte (213) gehört und die dem Verbindungsabschnitt (212) zugewandt ist, an einer Fläche anliegt, die zu der ersten Leiterplatte (23) gehört und die von der zweiten Leiterplatte (24) abgewandt ist, und der Verbindungsabschnitt (212) durch die erste Leiterplatte (23) verläuft und sich auf einer Seite befindet, die zu der ersten Leiterplatte (23) gehört und die der zweiten Leiterplatte (24) zugewandt ist.

5. Ladestecker (10) nach Anspruch 4, wobei eine Seite, die zu dem Wärmetauscher (31) gehört und die dem Anschlussstück (211) zugewandt ist, mit einer Kerbe (Q) bereitgestellt ist und zwischen der Kerbe (Q) und der wärmeleitenden Platte (32) ein Kerbspalt ausgebildet ist; und
eine orthografische Projektion eines Endes, das zu der Kerbe (Q) gehört und das sich in der Nähe der wärmeleitenden Platte (32) auf der wärmeleitenden Platte (32) befindet, eine erste Projektion ist, eine orthografische Projektion eines Endes, das zu dem Wärmetauscher (31) gehört und das dem Anschlussstück (211) auf der wärmeleitenden Platte (32) zugewandt ist, eine zweite Projektion ist und die erste Projektion sich auf einer Seite befindet, die zu der zweiten Projektion gehört und die von dem Anschlussstück (211) abgewandt ist.

6. Ladestecker (10) nach Anspruch 4 oder 5, wobei der Ladestecker (10) ferner ein Isolierelement (5) umfasst, das Isolierelement (5) einen Isolierkörper (51) umfasst und der Isolierkörper (51) zwischen dem Wärmetauscher (31) und der ersten Leiterplatte (23) angeordnet ist.

7. Ladestecker (10) nach Anspruch 6, wobei das Isolierelement (5) einen ersten Isolierabschnitt (52) und einen zweiten Isolierabschnitt (53) umfasst, die mit dem Isolierkörper (51) verbunden sind; und
in einer Richtung, in der die strukturelle Rippenplatte (213) auf den Verbindungsabschnitt (212) zeigt, sich der erste Isolierabschnitt (52) bis zu einer Position zwischen dem Wärmetauscher (31) und der wärmeleitenden Platte (32) erstreckt und sich der zweite Isolierabschnitt (53) bis zu einer Seitenfläche des Wärmetauschers (31) erstreckt.

8. Ladestecker (10) nach einem der Ansprüche 1 bis 7, wobei der Ladestecker (10) ferner zwei Anpressplatten (4) umfasst, die zwei Anpressplatten (4) entlang einer Dickenrichtung des Wärmetauschers (31) gegenüberliegend angeordnet sind, der Wärmetauscher (31), die wärmeleitende Platte (32) und der Verbindungsabschnitt (212) des Leistungsanschlusses (21) zwischen den zwei Anpressplatten (4) eingeklemmt sind und jede Anpressplatte (4) an einer Innenwand des Gehäuses (1) anliegt.

9. Ladestecker (10) nach Anspruch 8, wobei die zwei Anpressplatten (4) eine erste Anpressplatte (41) umfassen, die mit dem Wärmetauscher (31) in Kontakt steht, und eine Anpressfeder (411) auf einer Seite angeordnet ist, die zu der ersten Anpressplatte (41) gehört und die dem Wärmetauscher (31) zugewandt ist.

10. Ladevorrichtung, umfassend eine Ladesäule (20), ein Verbindungskabel (30) und einen Ladestecker (10) nach Anspruch 1, wobei
die Ladesäule (20) eine Leistungsverteilungseinheit (202), einen Flüssigkeitsspeichertank (203) und eine Steuereinheit (204) umfasst, wobei die Steuereinheit (204) dazu konfiguriert ist, basierend auf einem Status einer Signalverbindung zwischen dem Signalanschluss (22) und einem Elektrofahrzeug, die Leistungsverteilungseinheit (202) derart zu steuern, dass sie die zwei Leistungsanschlüsse (21) mit Leistung versorgt, die Leistungsverteilungseinheit (202) ein Leistungsverteilungsmodul (2021) und ein Leistungsmodul (2022) beinhaltet, das Leistungsverteilungsmodul (2021) elektrisch mit dem Leistungsmodul (2022) verbunden ist, das Leistungsmodul (2022) dazu konfiguriert ist, einen Wechselstrom in einen Gleichstrom umzuwandeln; ein Kühlmedium in dem Flüssigkeitsspeichertank (203) gespeichert ist; das Verbindungskabel (30) zwei Kabel (301) und ein Flüssigkeitskühlrohr (302) umfasst, die zwei Kabel (301) und die zwei Leistungsanschlüsse (21) in einer Eins-zu-Eins-Entsprechung miteinander verbunden sind; ein Leistungskabel in jedem Kabel (301) zwischen dem Leistungsverteilungsmodul (2021) der Leistungsverteilungseinheit (202) und dem entsprechenden Leistungsanschluss (21) verbunden ist; ein Signalkabel in jedem Kabel (301) zwischen der Steuereinheit (204) und der zweiten Leiterplatte (24) verbunden ist; und ein Ende des Flüssigkeitskühlrohrs (302) mit dem Wärmeaustausch-Hohlraum (S) des Wärmetauschers (31) in Verbindung steht und das andere Ende des Flüssigkeitskühlrohrs (302) mit dem Flüssigkeitsspeichertank (203) in Verbindung steht.

11. Ladevorrichtung nach Anspruch 10, wobei eine erste Wasserdüse (3111) und zwei zweite Wasserdüsen (3112) in dem Wärmetauscher (31) angeordnet sind und eine erste Wasseröffnung (2031) und zwei zweite Wasseröffnungen (2032) in dem Flüssigkeitsspeichertank (203) angeordnet sind; und das Flüssigkeitskühlrohr (302) ein erstes Rohr (3021) und zwei zweite Rohre (3022) umfasst, das erste Rohr (3021) zwischen der ersten Wasserdüse (3111) und der ersten Wasseröffnung (2031) verbunden ist, die zwei zweiten Wasseröffnungen (2032), die zwei zweiten Rohre (3022) und die zwei zweiten Wasserdüsen (3112) in einer Eins-zu-Eins-Entsprechung stehen und ein zweites Rohr (3022) zwischen einer zweiten Wasserdüse (3112) und einer zweiten Wasseröffnung (2032) verbunden ist.

12. Ladevorrichtung nach Anspruch 11, wobei die Anzahl von Kabeln (301) zwei beträgt, zwei Kabel (301) eins zu eins den zwei zweiten Rohren (3022) entsprechen, jedes Kabel (301) ein Endstück (3011) und ein Drahtstück umfasst und das Endstück (3011) dazu konfiguriert ist, den Leistungsanschluss (21) mit der zweiten Leiterplatte (24) zu verbinden; und das Drahtstück eine Vielzahl von leitenden Drähten (3012) umfasst und die Vielzahl von leitenden Drähten (3012) um das erste Rohr (3021) herum angeordnet ist oder die Vielzahl von leitenden Drähten (3012) um das entsprechende zweite Rohr (3022) herum angeordnet ist.

## Revendications

1. Connecteur de charge (10), comprenant un boîtier (1), une structure de connexion électrique (2) et une structure de refroidissement liquide (3), dans lequel la structure de connexion électrique (2) et la structure de refroidissement liquide (3) sont disposées dans le boîtier (1) ;
la structure de connexion électrique (2) comprend une première carte de circuit imprimé (23), une seconde carte de circuit imprimé (24), une borne de signal (22) et deux bornes d'alimentation (21), dans lequel la première carte de circuit imprimé (23) est fixée au boîtier (1), le long d'une direction axiale des bornes d'alimentation (21), la première carte de circuit imprimé (23) a une première face d'extrémité et une seconde face d'extrémité qui sont opposées l'une à l'autre, la borne de signal (22) est reliée à la première face d'extrémité de la première carte de circuit imprimé (23), et la seconde carte de circuit imprimé (24) est reliée à la seconde face d'extrémité de la première carte de circuit imprimé (23), la borne de signal (22) est reliée électriquement à la première carte de circuit imprimé (23), la première carte de circuit imprimé (23) est reliée électriquement à la seconde carte de circuit imprimé (24), la seconde carte de circuit imprimé (24) est configurée pour se connecter à un câble de signal dans un câble (301) ; ledit câble (301) est inclus dans un câble de connexion (30) qui configuré pour être connecté au connecteur de charge (10) ;
les deux bornes d'alimentation (21) sont montées côte à côte sur la première carte de circuit imprimé (23), chaque borne d'alimentation (21) est isolée de la première carte de circuit imprimé (23), et chaque borne d'alimentation (21) a une partie de connexion (212) située sur un côté sur lequel la seconde face d'extrémité de la première carte de circuit imprimé (23) est située, une surface d'échange de chaleur (M1) est disposée sur la partie de connexion (212), la surface d'échange de chaleur (M1) est parallèle à la direction axiale de la borne d'alimentation (21), et les surfaces d'échange de chaleur (M1) des deux bornes d'alimentation (21) sont coplanaires ; et
la structure de refroidissement liquide (3) comprend un échangeur de chaleur (31) et une plaque thermoconductrice (32), l'échangeur de chaleur (31) a une cavité d'échange de chaleur (S), la cavité d'échange de chaleur (S) est configurée pour accueillir un fluide de refroidissement, la plaque thermoconductrice (32) est en contact avec les surfaces d'échange de chaleur (M1) des deux bornes d'alimentation (21), et l'échangeur de chaleur (31) est en contact avec la plaque thermoconductrice (32),
dans lequel une structure de canal d'écoulement (3113) est disposée dans la cavité d'échange de chaleur (S) de l'échangeur de chaleur (31), la structure de canal d'écoulement (3113) comprend une première section de canal d'écoulement (31131) et deux secondes sections de canal d'écoulement (31132), les deux secondes sections de canal d'écoulement (31132) sont séparément en communication avec la première section de canal d'écoulement (31131), et les deux secondes sections de canal d'écoulement (31132) sont en correspondance biunivoque avec les surfaces d'échange de chaleur (M1) des deux bornes d'alimentation (21) ; la première section de canal d'écoulement (31131) est disposée entre les deux secondes sections de canal d'écoulement (31132) ; et
entre la seconde section de canal d'écoulement (31132) et la surface d'échange de chaleur (M1) de la borne d'alimentation (21) qui correspondent l'une à l'autre, une projection orthographique de la seconde section de canal d'écoulement (31132) sur la plaque thermoconductrice (32) recouvre une projection orthographique de la surface d'échange de chaleur (M1) de la borne d'alimentation (21) sur la plaque thermoconductrice (32).

2. Connecteur de charge (10) selon la revendication 1, dans lequel une première buse d'eau (3111) et deux secondes buses d'eau (3112) sont disposées dans l'échangeur de chaleur (31), la première buse d'eau (3111) est en communication avec la première section de canal d'écoulement (31131), et les deux secondes buses d'eau (3112) sont en communication avec les deux secondes sections de canal d'écoulement (3112) dans une correspondance biunivoque.

3. Connecteur de charge (10) selon la revendication 23, dans lequel une section transversale d'écoulement de la première buse d'eau (3111) est supérieure à une section transversale d'écoulement de toute seconde buse d'eau (3112).

4. Connecteur de charge (10) selon l'une quelconque des revendications 1 à 3, dans lequel un joint (211) est formé au niveau d'une extrémité qui est de chaque borne d'alimentation (21) et qui est éloignée de la partie de connexion (212), et une plaque nervurée structurelle (213) est formée entre le joint (211) et la partie de connexion (212), dans une direction perpendiculaire à la direction axiale de la borne d'alimentation (21), une taille de la plaque nervurée structurelle (213) est supérieure à une taille du joint (211) et une taille de la partie de connexion (212) ;
une surface qui est de la plaque nervurée structurelle (213) et qui fait face à la partie de connexion (212) vient en butée contre une surface qui est de la première carte de circuit imprimé (23) et qui est éloignée de la seconde carte de circuit imprimé (24), et la partie de connexion (212) traverse la première carte de circuit imprimé (23) et est située sur un côté qui est de la première carte de circuit imprimé (23) et qui fait face à la seconde carte de circuit imprimé (24).

5. Connecteur de charge (10) selon la revendication 4, dans lequel un côté qui est de l'échangeur de chaleur (31) et qui fait face au joint (211) est muni d'une encoche (Q), et un espace d'encoche est formé entre l'encoche (Q) et la plaque thermoconductrice (32) ; et
une projection orthographique d'une extrémité qui est de l'encoche (Q) et qui est proche de la plaque thermoconductrice (32) sur la plaque thermoconductrice (32) est une première projection, une projection orthographique d'une extrémité qui est de l'échangeur de chaleur (31) et qui fait face au joint (211) sur la plaque thermoconductrice (32) est une seconde projection, et la première projection est située sur un côté qui est de la seconde projection et qui est éloigné du joint (211).

6. Connecteur de charge (10) selon la revendication 4 ou 5, dans lequel le connecteur de charge (10) comprend en outre un élément isolant (5), l'élément isolant (5) comprend un corps isolant (51), et le corps isolant (51) est disposé entre l'échangeur de chaleur (31) et la première carte de circuit imprimé (23).

7. Connecteur de charge (10) selon la revendication 6, dans lequel l'élément isolant (5) comprend une première partie isolante (52) et une seconde partie isolante (53) qui sont reliées au corps isolant (51) ; et
dans une direction dans laquelle la plaque nervurée structurelle (213) pointe vers la partie de connexion (212), la première partie isolante (52) s'étend jusqu'à une position entre l'échangeur de chaleur (31) et la plaque thermoconductrice (32), et la seconde partie isolante (53) s'étend jusqu'à une surface latérale de l'échangeur de chaleur (31).

8. Connecteur de charge (10) selon l'une quelconque des revendications 1 à 7, dans lequel le connecteur de charge (10) comprend en outre deux plaques de pression (4), les deux plaques de pression (4) sont disposées de manière opposée dans une direction d'épaisseur de l'échangeur de chaleur (31), l'échangeur de chaleur (31), la plaque thermoconductrice (32) et la partie de connexion (212) de la borne d'alimentation (21) sont serrés entre les deux plaques de pression (4), et chaque plaque de pression (4) vient en butée contre une paroi interne du boîtier (1).

9. Connecteur de charge (10) selon la revendication 8, dans lequel les deux plaques de pression (4) comprennent une première plaque de pression (41) en contact avec l'échangeur de chaleur (31), et une lame de pression (411) est disposée sur un côté qui est de la première plaque de pression (41) et qui fait face à l'échangeur de chaleur (31).

10. Dispositif de charge, comprenant une borne de charge (20), un câble de connexion (30) et un connecteur de charge (10) selon la revendication 1, dans lequel
la borne de charge (20) comprend une unité de distribution d'énergie (202), un réservoir de stockage de liquide (203) et une unité de commande (204), dans lequel l'unité de commande (204) est configurée pour commander, sur la base d'un état de connexion de signal entre la borne de signal (22) et un véhicule électrique, l'unité de distribution d'énergie (202) afin d'alimenter les deux bornes d'alimentation (21), l'unité de distribution d'énergie (202) comporte un module de distribution d'énergie (2021) et un module d'alimentation (2022), le module de distribution d'énergie (2021) est connecté électriquement au module d'alimentation (2022), le module d'alimentation (2022) est configuré pour convertir un courant alternatif en un courant continu ; un fluide de refroidissement est stocké dans le réservoir de stockage de liquide (203) ; le câble de connexion (30) comprend deux câbles (301) et un tuyau de refroidissement liquide (302), les deux câbles (301) et les deux bornes d'alimentation (21) sont connectés selon une correspondance biunivoque ; un câble d'alimentation dans chaque câble (301) est connecté entre le module de distribution d'énergie (2021) de l'unité de distribution d'énergie (202) et la borne d'alimentation correspondante (21) ; un câble de signal dans chaque câble (301) est relié entre l'unité de commande (204) et la seconde carte de circuit imprimé (24) ; et une extrémité du tuyau de refroidissement liquide (302) est en communication avec la cavité d'échange de chaleur (S) de l'échangeur de chaleur (31), et l'autre extrémité du tuyau de refroidissement liquide (302) est en communication avec le réservoir de stockage de liquide (203).

11. Dispositif de charge selon la revendication 10, dans lequel une première buse d'eau (3111) et deux secondes buses d'eau (3112) sont disposées dans l'échangeur de chaleur (31), et une première ouverture d'eau (2031) et deux secondes ouvertures d'eau (2032) sont disposées dans le réservoir de stockage de liquide (203) ; et le tuyau de refroidissement de liquide (302) comprend un premier tuyau (3021) et deux seconds tuyaux (3022), le premier tuyau (3021) est relié entre la première buse d'eau (3111) et la première ouverture d'eau (2031), les deux secondes ouvertures d'eau (2032), les deux seconds tuyaux (3022) et les deux secondes buses d'eau (3112) sont en correspondance biunivoque, et un second tuyau (3022) est relié entre une seconde buse d'eau (3112) et une seconde ouverture d'eau (2032).

12. Dispositif de charge selon la revendication 11, dans lequel le nombre de câbles (301) est de deux, deux câbles (301) sont en correspondance biunivoque avec les deux seconds tuyaux (3022), chaque câble (301) comprend une partie d'extrémité (3011) et une partie de fils, et la partie d'extrémité (3011) est configurée pour relier la borne d'alimentation (21) à la seconde carte de circuit imprimé (24) ; et la partie de fils comprend une pluralité de fils conducteurs (3012), et la pluralité de fils conducteurs (3012) sont disposés autour du premier tuyau (3021), ou la pluralité de fils conducteurs (3012) sont disposés autour du second tuyau (3022) correspondant.
